# EUROPEAN PATENT APPLICATION

(11) **EP 1 857 294 A1**
(43) Date of publication of application: **21.11.2007**
(21) Application number: 06713472.6
(22) Date of filing: 10.02.2006
(51) Int. Cl.: B41N 1/14, B41C 1/055, G03F 7/00, G03F 7/004, G03F 7/11

(54) **MATERIAL OF LITHOGRAPHIC PRINTING PLATE, PROCESS FOR PRODUCING MATERIAL OF LITHOGRAPHIC PRINTING PLATE, AND METHOD OF PRINTING**

(30) Priority: 11.03.2005 JP 2005068626
(71) Applicant: Konica Minolta Medical & Graphic, Inc., Tokyo 163-0512 (JP)
(72) Inventor: MAEHASHI, Tatsuichi, ikawa-machi, Hachioji-shi, Tokyo, 192850 (JP)
(74) Representative: Rees, Alexander Ellison
(86) International application number: PCT/JP2006/302329
(87) International publication number: WO 2006/095534

(57) **Abstract**

The Object of the invention is to provide a lithographic printing plate material excellent in the on-press developability, running durability, and resistivity to pressure fogging, the production method of the lithographic printing plate material and the printing method using the lithographic printing plate material. The above object can be attained by a lithographic printing plate material having a hydrophilic layer and a thermo-sensitive image forming layer piled on a support in which the hydrophilic layer is formed by coating a coating composition containing a compound having an addition polymerizable unsaturated bond and a polymerization initiator onto a support and polymerizing the compound having the addition polymerizable unsaturated bond.

## Description

### FIELD OF THE INVENTION

This invention relates to a lithographic printing plate material to be developed on a printing machine after image writing, a production method of the lithographic printing plate material, and a printing method using the lithographic printing plate material.

### TECHNICAL BACKGROUND

Recently, a computer to plate (CTP) system in which image data are directly recorded on a printing plate has been populated accompanied with digitalization of the printing data. Printing plate materials to be used in the CTP system usually include an aluminum type plate using an aluminum substrate similar to that to be used in usual PS plates and a flexible type plate composed of a film substrate and a layer functioning as printing plate provided on the film.

Tendency of decreasing in the volume and increasing in the variety of products is recently progressed in the field of commercial printing and the demand for printing plate with high quality and low price is raised in the market. Hitherto, the following materials are known, for example, a printing plate material composed of a film substrate described in JP O.P.I. No. 5-66564 on which a light sensitive layer of silver salt diffusion transfer system is provided, a material composed of a film substrate on which a hydrophilic layer and an oleophilic layer are piled so that one of which is the surface layer and the surface layer is ablated by laser exposition to form a printing plate disclosed in JP O.P.I. Nos. 8-507727, 6-186750, 6-199064, 7-414934, 10-58636 and 10-244773, and a material disclosed in JP O.P.I. No. 2000-96710 which is composed of a film substrate on which a hydrophilic layer and a thermally fusible image forming layer are provided and the image forming layer is fused and fixed on the hydrophilic layer by imagewise heating the hydrophilic layer or the image forming layer by exposing to laser light.

As an image forming method for printing, a method so called as on-press development is known in which a plate is directly set on a offset printing machine after writing of image data (imagewise exposure) and subjected to printing operation so that the non-image portion of the image forming layer is only swollen and dissolved by the dampening water and removed by transferring onto printing paper (lost paper) at the initial period of printing operation; cf. Patent Documents 1 and 2. Such the method is advantageous from the viewpoint of environmental protection. These on-press developable printing plate materials give sharp dot shape and high definition images and superior in the environmental suitability since any developing process after exposure is not necessary.

However, such the printing plate materials causes problems of that the running durability is insufficient and pressure fogging in non-image area before development tends to be causes because the strength of the image forming layer is insufficient itself. For corresponding to such the problems, improvement is carried out by addition of a water-soluble resin or a thermoplastic resin, cf. Patent Document 3. In a case of using blocking powder, however, problems are newly caused that the running durability is made insufficient and the addition of a resin having high viscosity in a dissolved state causes lowering in the on-press developability and increasing in energy consumption necessary for image formation (lowering in sensitivity) so as to lower the production efficiency.
Patent Document 1: JP O.P.I. No. 9-123387
Patent Document 2: JP O.P.I. No. 9-123388
Patent Document 3: JP O.P.I. No. 2000-238451

### DISCLOSURE OF THE INVENTION

### [Problems to be solved by the invention]

The present invention is attained on the above background, and an object of the invention is to provide a lithographic printing plate material excellent in the on-press developability, running durability and pressure fogging resistivity, a production method of the lithographic print plate material and a printing method using the lithographic printing plate material.

### [Means for solving the problems]

As a result of the investigation by the inventors, it is found that a lithographic printing plate material excellent in the running durability and resistivity against pressure fogging before development even when the blocking powder is used can be obtained without lowering in the on-press developability by adding a compound having an unsaturated addition polymerizable bond to a hydrophilic layer and the compound is polymerized on the occasion of the production of the printing plate material or coating the hydrophilic layer coating composition.

The object of the invention can be attained by the following constitution.
1. A lithographic printing plate material for on-press development having a hydrophilic layer and a thermo-sensitive image forming layer piled on a support, wherein the hydrophilic layer is formed by coating a coating composition containing a compound having an addition polymerizable unsaturated bond and a polymerization initiator onto the support and thereafter polymerizing the compound having the addition polymerizable unsaturated bond.
2. The lithographic printing plate material described in 1, wherein the compound having the addition polymerizable unsaturated bond and the polymerization initiator each has a water solubility of not less than 1% by weight.
3. A production method of a lithographic printing plate material for on-press development having a hydrophilic layer and a thermo-sensitive image forming layer piled on a support, wherein the hydrophilic layer is formed by coating a coating composition containing a compound having an addition polymerizable unsaturated bond and a polymerization initiator onto the support and polymerizing the compound having the addition polymerizable unsaturated bond by light or heat.
4. The production method of a lithographic printing plate material described in 3, wherein the compound having the addition polymerizable unsaturated bond and the polymerization initiator each has a water solubility of not less than 1% by weight.
5. A printing method comprising the steps of forming an image on the lithographic printing plate material described in 1 or 2 by using a thermal head or a thermal laser and thereafter developing the image by dampening water or both dampening water and printing ink on a lithographic printing machine and printing.

### [Effects of the invention]

A lithographic printing plate material excellent in the on-press developability, the running durability and the resistivity against pressure fogging, a production method of the lithographic printing plate material and a printing method using the lithographic printing plate material can be provided by the invention.

### [The best embodiment for embodying the invention]

The best embodiment for embodying the invention is described below, but the invention is not limited to the description.

The invention is described in detail below.

The lithographic printing plate material of the invention is an on-press development lithographic printing plate material comprising a hydrophilic layer and a thermally image forming layer piled on a support. In the invention, it is essential that the coating composition for forming the hydrophilic layer contain a compound having an unsaturated addition polymerizable bond and a polymerization initiator.

When the printing plate material comprises plural hydrophilic layers piled together with, the compound having the unsaturated addition polymerizable bond and the polymerization initiator may be added in one of or entire layers. When the compound and the initiator are added in one layer, addition into the hydrophilic layer being at the nearest position to the support is more preferable.

The compound having the unsaturated addition polymerizable bond is a compound having an ethylenic unsaturated radical polymerizable. The compound may be any one having at least one ethylenic unsaturated radical polymerizable bond (radical polymerizable compound) which may be in a state of monomer, oligomer or polymer. When the radical polymerizable compound is used in the coating composition of the hydrophilic layer, the compound may be used solely or in combination of two or more kinds thereof in an optional ratio.

The radical polymerizable compound preferably usable in the invention is one having solubility in purified water of not less than 1%, more preferably not less than 5%, by weight at 25 °C under 1 atmosphere.

As such the compound, the followings are cited:
(1) A reaction product of a dibasic acid anhydride and a hydroxyl group-containing acrylate or a hydroxyl group-containing methacrylate; typically a reaction product of succinic anhydride, o-phthalic anhydride or maleic anhydride with 2-hydroxyethyl methacrylate or 3-chloro-2-hydroxypropyl methacrylate.
(2) A reaction product of secondary hydroxyl group of an acrylate of an epoxy resin with a dibasic acid anhydride; typically a compound obtained by making to react an acrylate with bisphenol type epoxy resin Epikote® 828 or Epikote® 1001, manufactured by Yuka-Shell Epoxy Co., Ltd., polyol aliphatic epoxy resin DENACOL®, manufactured by Nagase Kasei Co., Ltd., 1,4-butanediol glycidyl ether, trimethylolpropane glycidyl ether or pentaerythritolyl glycidyl ether, alicyclic epoxy resin Celoxide®, manufactured by Daicel Chemical Industries Co., Ltd., and then making react succinic anhydride or maleic anhydride with hydroxyl group remaining or newly produced in the above reaction product.
(3) A reaction product of polyol ester of acrylic acid or methacrylic acid with a dibasic acid anhydride; typically a compound obtained by making to react an acrylate of glycol or polyethylene glycol with succinic anhydride or maleic anhydride; the glycol or polyethylene glycol to be used is preferably one having a molecular weight of not more than about 600.
(4) Water soluble urethane acrylate and methacrylate having a carboxyl group side chain in the molecular chain thereof; Synthesis of oligomer as UV curable resin is known. A polybasic acid such as trimellitic anhydride or a compound having two hydroxyl groups and one carboxyl group in a molecule such as dimethylol propionic acid are used in the course of the synthesis process for synthesizing the oligomer having the carboxyl group side chain.

The above-exemplified Compounds 1 through 4 are neutralized by a base for making water soluble. Concrete examples of the base include ammonia, methylamine, ethylamine, dimethylamine, diethylamine, n-butylamine, di-n-butylamine, trimethylamine, ethylenediamine, diethylenetriamine, triethylenetetramine, tetraethylenepentamine, propylenediamine, ethanolamine, hexylamine, laurylamine, diethanolamine, triethanolamine, morpholine, piperidine, propylamine, isopropylamine, isobutylamine, NaOH, LiOH and KOH.

As the radical polymerizable compound to be used in the invention, water-soluble radical polymerizable compounds are usable. Examples of such the compound include methoxypolyethyleneglycol (N=9) acrylate, methoxypolyethyleneglycol (N=9) methacrylate, β-carboxyethyl acrylate, acryloylmorphone, diacetoneacrylamide, vinylformamide, N-vinylpyrrolidone, nanoethyleneglyol dimethacrylate and ethoxide glycerol triacrylate (adduct of 20 moles of EO), but the invention is not limited to them.

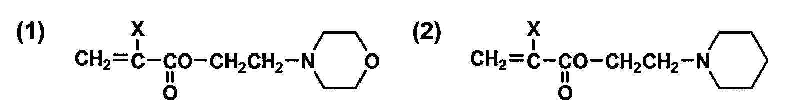

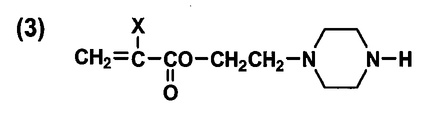

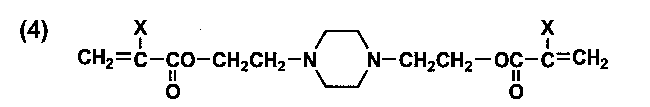

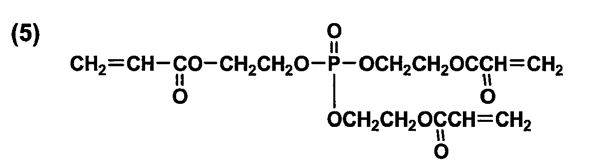

**CH₂=CHCOOCH₂CH₂OOCCH₂CH₂COOH** **(6)**

**CH₂=CHCOO(CH₂CH₂COO)ₙ-H (n is an integer of from 1 to 4)** **(7)**

**CH₂=CHCOO(CH₅H₁₀COO)ₙ-H (n is an integer of from 1 to 5)** **(8)**

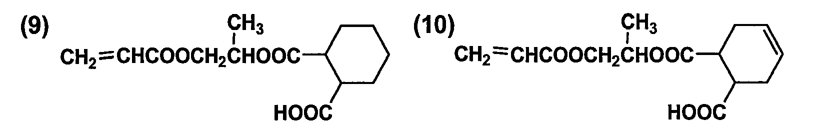

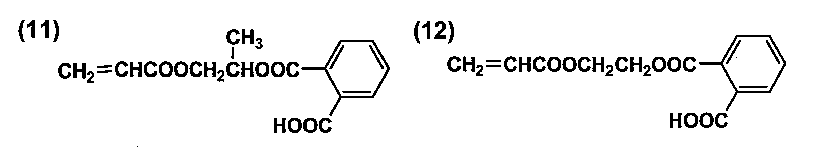

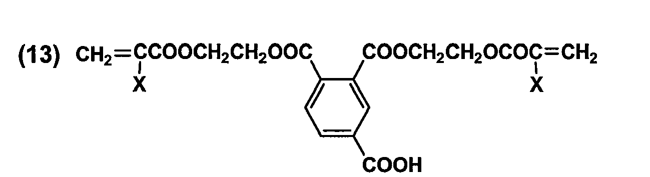

X in the above (1) to (4) and (13) is a hydrogen atom or a methyl group.

A compound polymerizable by UV rays is usable as the radical polymerizable compound relating to the invention. The UV polymerizable compound is selected from, for example, a water-soluble polymerizable compound represented by the following Formula 1, for example, a compound in which R is a bonding group having a group derived from a polyol and bonded with A through a polyol residue (through a -O-), hereinafter referred to as a compound represented by Formula A, and a compound in which R is a bonding group having a group derived from a polyol and bonded with A through the residue formed by removing -O- from the polyol residue (not through -O-).

Formula 1 [Z]_{L} - R -[A]_{K}

In the above formula, K is an integer of 2 or 3, L is an integer of 1 or 2, Z is -COO⁻ or its salt, and R is a bonding group at least derived from a polyol, and A is the following.

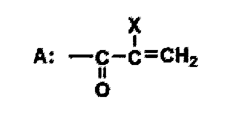

In the above formula, X is a hydrogen atom or a methyl group.

The polymerizable compound represented by Formula 1 can be more clearly represented by the following Formula 1'.

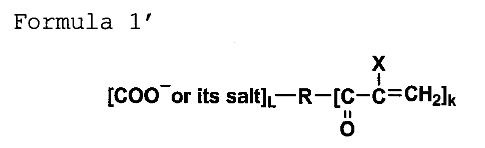

In the above formula, K is an integer of 2 or 3, L is an integer of 1 or 2, R is a bonding group at least derived from a polyol, and X is a hydrogen atom or a methyl group.

As preferable examples of the compound represented by Formula A, the following polymerizable compounds A1 to A11 are cited.

In the polymerizable compounds represented by Formulas A1 to A11, A, X, Rₓ, R_{y} and R_{z} each independently represents the following group of atoms. 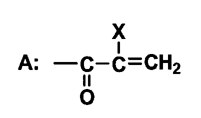 (X is H or CH₃)
**Rx,Ry,Rz: -(CH₂CH₂O)ₙ₁-(Bonding with A) (n1 = an integer of 0 to 5)**
or

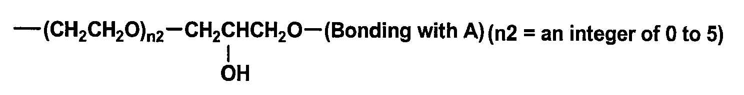

### Rp: One of the following (1-1) to (1-5)

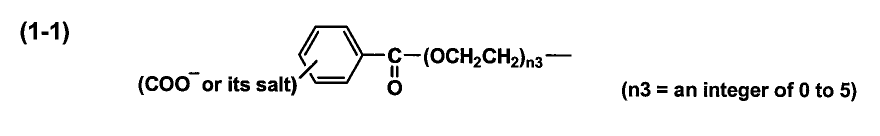

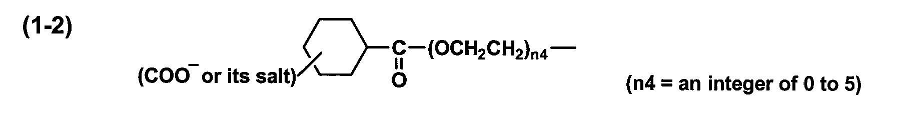

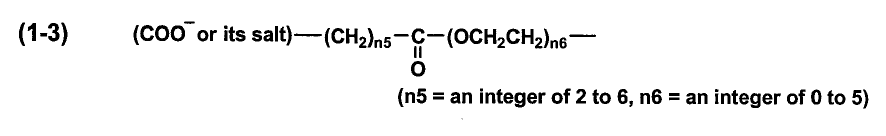

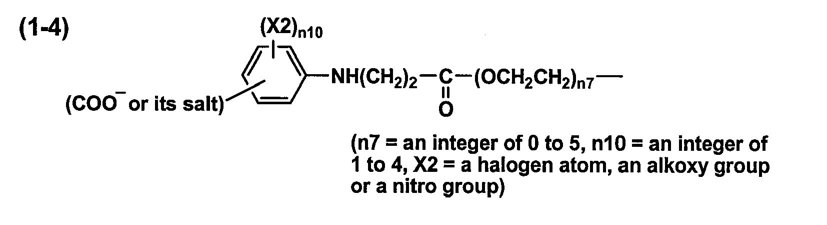

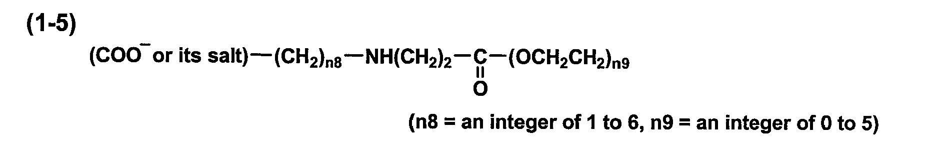

A fluorine atom, a chlorine atom or a bromine atom are cited as the halogen atom represented by X2 in the above Formula 1-4 representing a structure of Rp, and an alkoxy group having one to three carbon atoms are cited as the alkoxy group.

Compounds represented by the following Formula A1, concretely the polymerizable compounds A1-1 and A1-2 are usable.

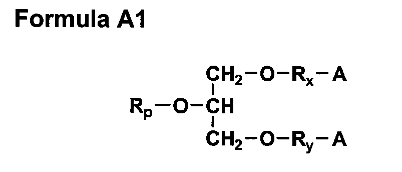

### Polymerizable compound A1-1

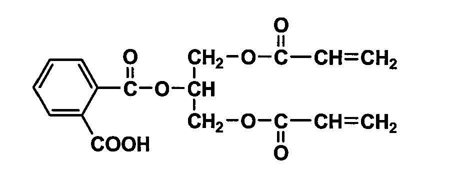

### Polymerizable compound A1-2

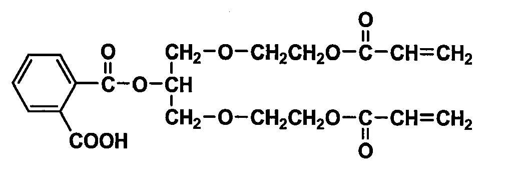

Compounds represented by the following Formula A2, concretely the polymerizable compounds A2-1 and A1-2 are usable.

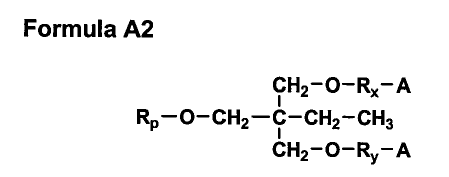

### Polymerizable compound A2-1

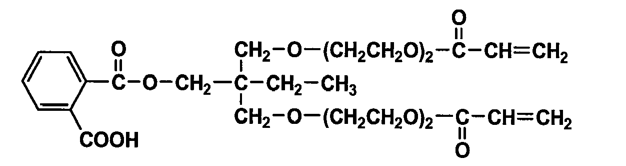

Compounds represented by the following Formula A3, concretely the following polymerizable compounds A3-1 to A3-4 are usable.

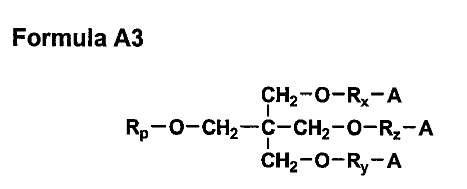

### Polymerizable compound A3-1

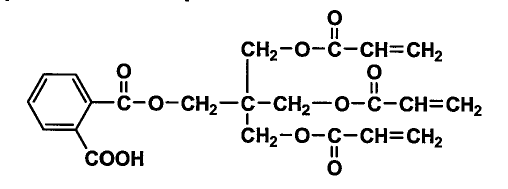

### Polymerizable compound A3-2

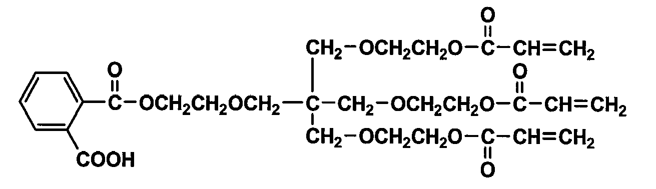

### Polymerizable compound A3-3

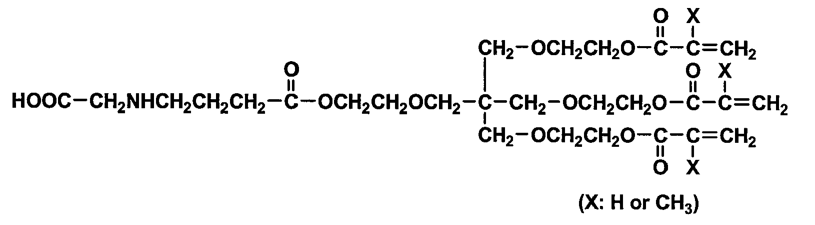

### Polymerizable compound A3-4

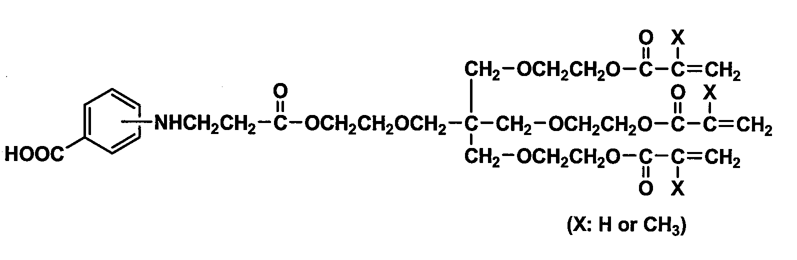

Compounds represented by the following Formula A4, concretely the following polymerizable compounds A4-1 are usable.

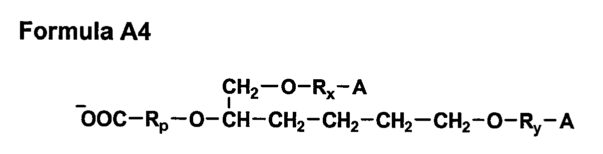

### Polymerizable compound A4-1

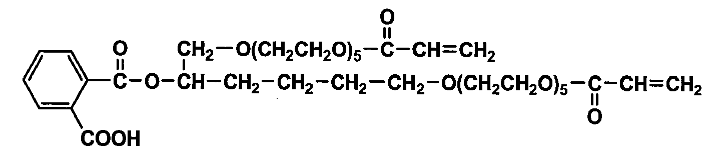

Compounds represented by the following Formula A5, concretely the following polymerizable compounds A5-1 are usable.

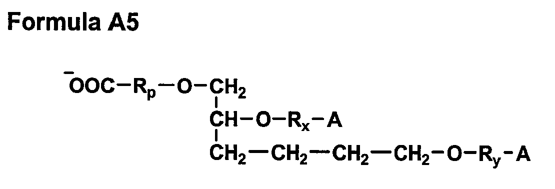

### Polymerizable compound A5-1

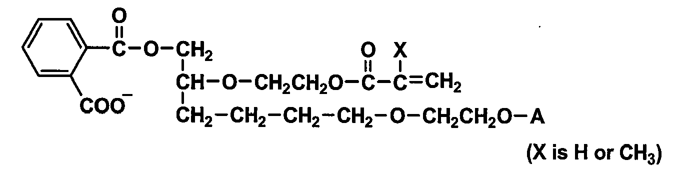

Moreover, compounds represented by the following Formulas A6 to A11 and various polymerizable compounds included in those compounds are usable.

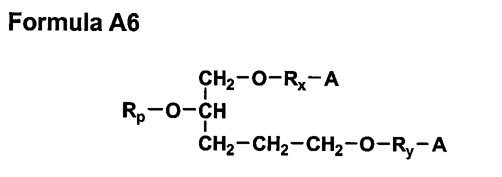

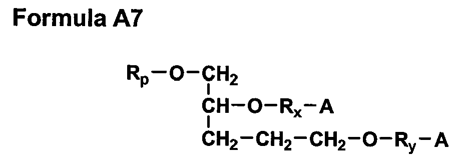

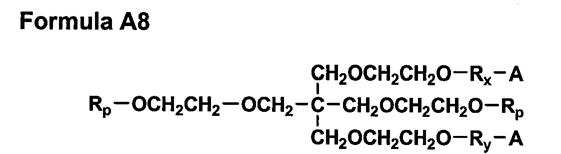

### Polymerizable compound A8-1

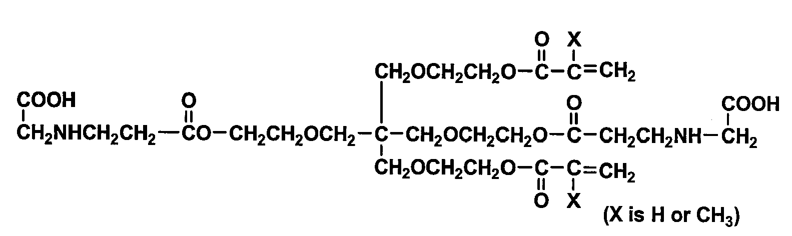

### Polymerizable copound A8-2

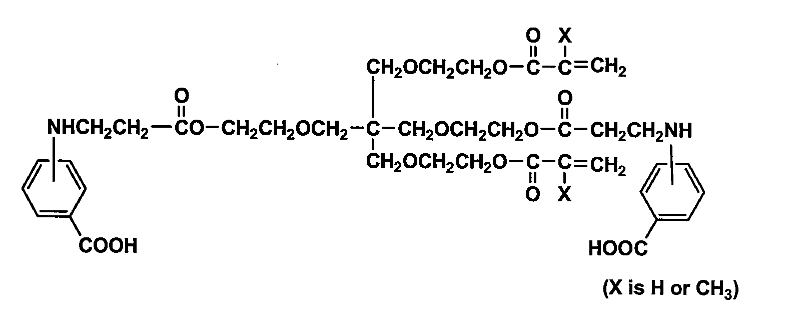

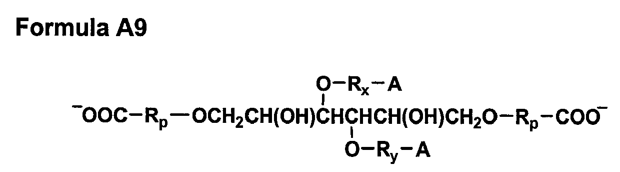

### Polymerizable compound A9-1

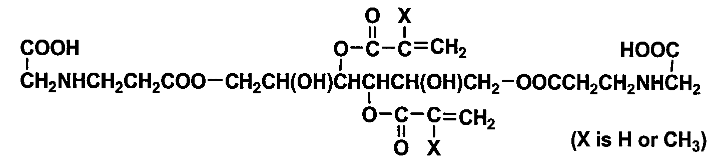

### Polymerizable compound A9-2

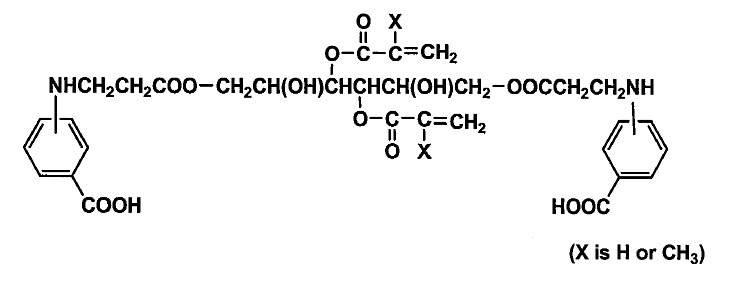

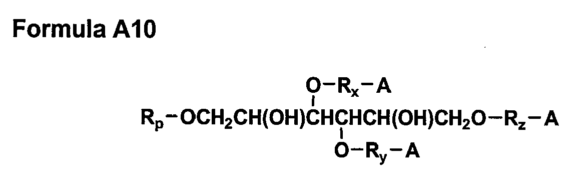

### Polymerizable compound A10-1

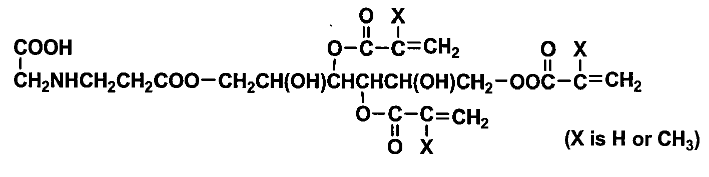

### Polymerizable compound A10-2

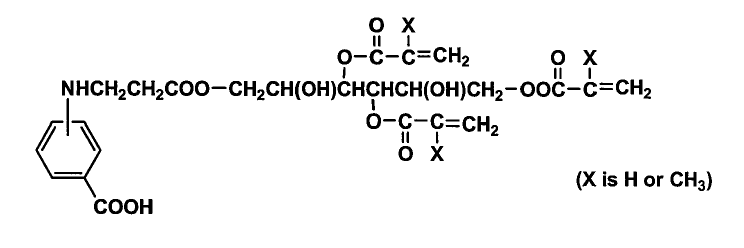

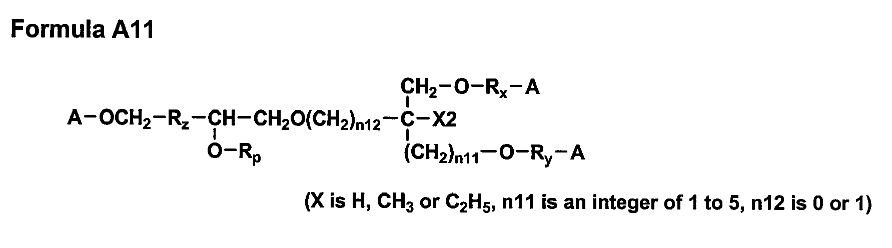

### Polymerizable A11-1

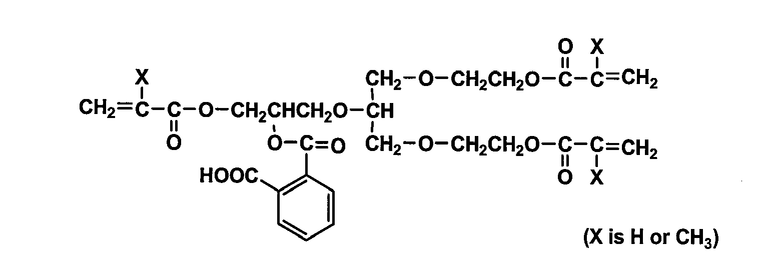

### Polymerizable A11-2

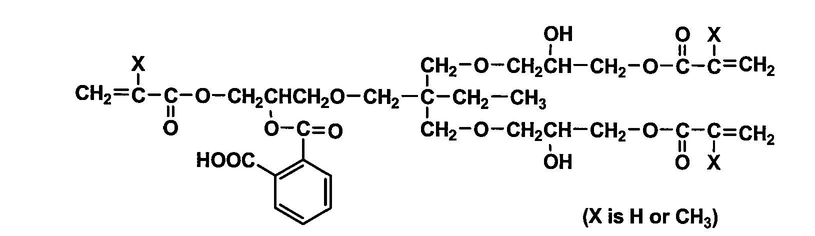

### Polymerizable A11-3

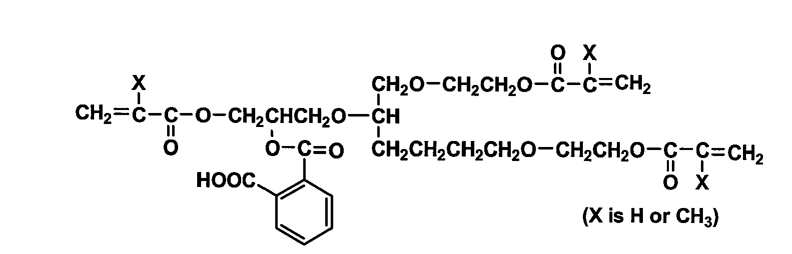

The foregoing polymerizable compounds A10-1 and A10-2 can be produced by adding an amine having a carboxyl group, namely an amino acid in broad sense, to the vinyl group of acrylic acid. Such the reaction can be generally represented as follows.

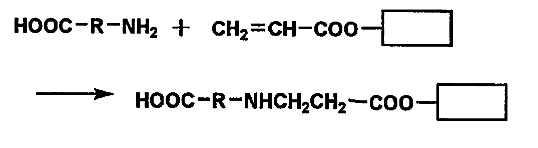

In the above, R is a methylene group in the case of the polymerizable compound A10-1 and a phenylene group in the case of the polymerizable compound A10-2. As the amine having a carboxyl group to be used in such the method, for example, p-aminobenzoic acid, glycine, valine, leucine, isoleucine, serine, threonine, methionine and phenylalanine are usable. Substances having the similar properties can be introduced from an amino acid having two carboxyl groups such as glutamic acid and aspartic acid.

The polymerizable compounds represented by the following Formula B1, B2, B3 or B4 are cited as concrete examples of the polymerizable compound represented by Formula B. In Formulas 1 to 4, A and Rp each represents the following groups of atoms. 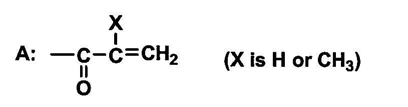 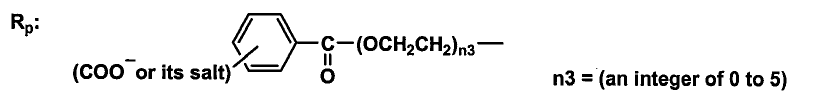 or

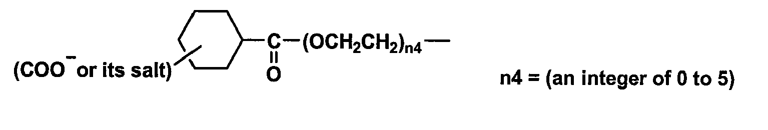

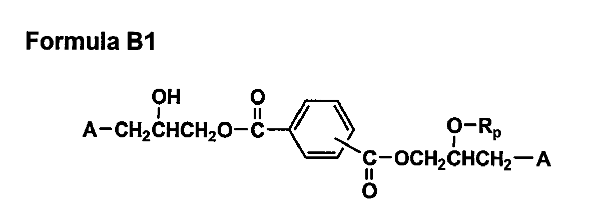

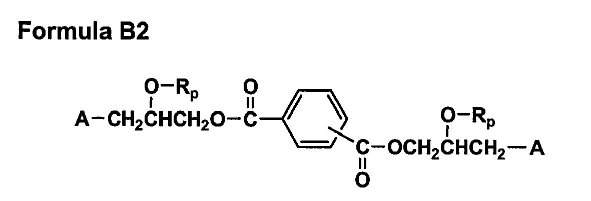

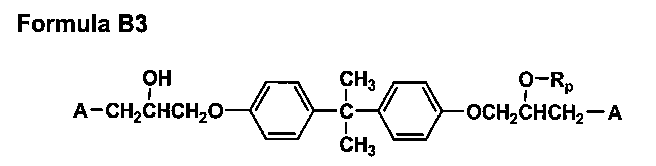

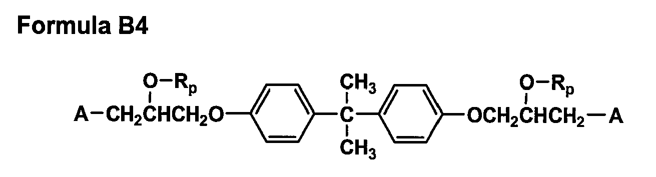

### Polymerizable compound B1-1

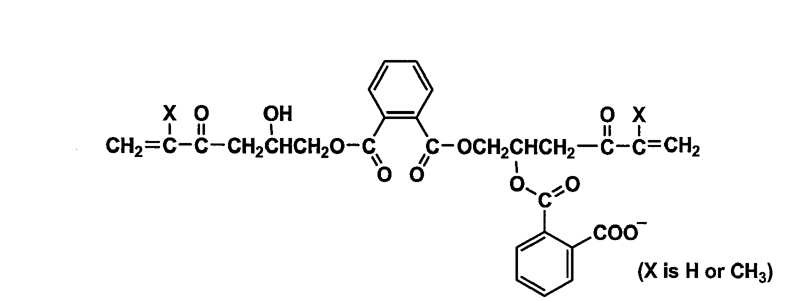

### Polymerizable compound B2-1

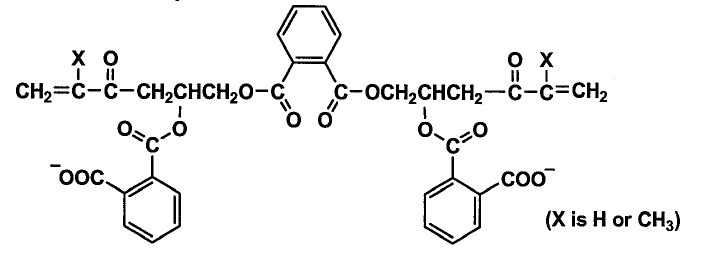

### Polymerizable compound B3-1

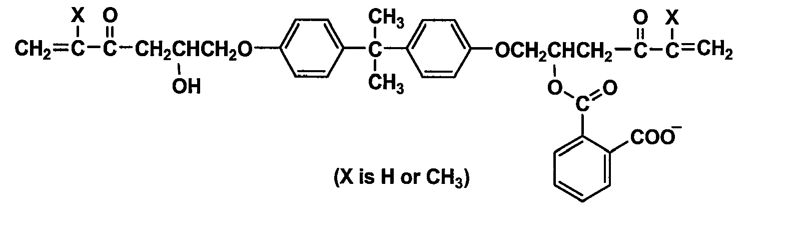

### Polymerizable compound B4-1

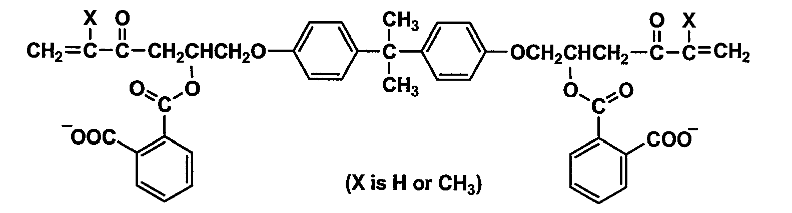

The compounds having three polymerizable functional groups are particularly superior in polymerization rate, hardness of the cured substance among the above-described many groups of compounds.

The content of the polymerizable compound of the invention is from 2 to 50%, preferably from 5 to 30%, by weight of the hydrophilic layer composition. When the content is less than 2% by weight, contribution on the strength of the hydrophilic layer after polymerization is small. When the content exceeds 50% by weight, the hydrophilicity of the layer after polymerization is lowered so as to lower the function as the printing plate.

### (Photopolymerization initiator)

The polymerization initiator is an agent capable of generating radical by light or heat so as to polymerize the compound having the addition polymerizable unsaturated bond. In the invention, it is preferable to progress the polymerization reaction on the occasion of production of the lithographic printing plate material, namely on the occasion of coating the hydrophilic layer coating composition. A compound capable of generating radical by activating by heat of about 100 °C or UV ray of not more than 400 nm is particularly preferred as the polymerization initiator.

The polymerization initiator is preferably has a solubility in purified water of not less than 0.1%, and more preferably not less than 1.0%, by weight at 25 °C under 1 atmosphere.

The polymerization initiators represented by the following formulas, hereinafter referred to as TX type, can be cited as concrete examples. It is particularly preferred in the invention to use one optionally selected from them.

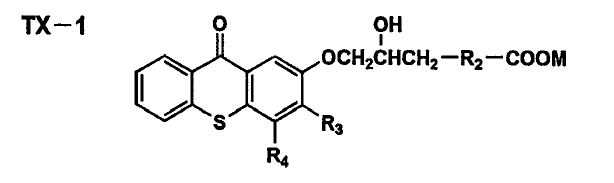

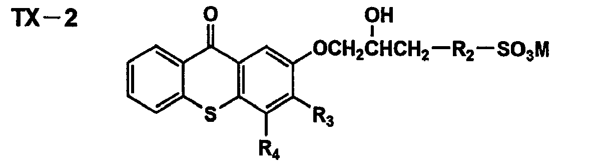

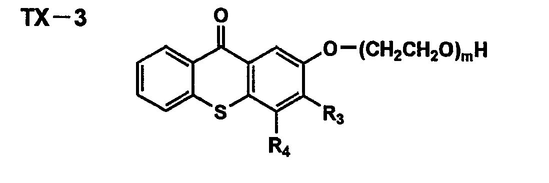

In the above Formulas TX-1 to TX-3, R₂ is a -(CH₂)ₓ- group in which x is 0 or 1, an -O-(CH₂)_{y}- group in which y is 1 or 2, or a substituted or unsubstituted phenylene group. When R₂ is a phenylene group, one or more hydrogen atoms of the benzene ring may be substituted by one or more substituent selected from, for example, a carboxyl group and its salt, a sulfonic acid group and its salt, a straight- of branched-chain alkyl group having 1 to 4 carbon atoms, a halogen atom such as a fluorine atom, chlorine atom and bromine, an alkoxy group having 1 to 4 carbon atoms and an aryloxy group such as a phenoxy group. M is a hydrogen atom or an alkali metal atom such as Li, Na and K. R₃ and R₄ are each independently a hydrogen atom or a substituted or unsubstituted alkyl group. As concrete example of the alkyl group, a straight- or branched-chain alkyl group having from 1 to 10, particularly from 1 to about 3, carbon atoms can be cited. Examples of the substituent of the alkyl group include a halogen atom such as a fluorine atom, chlorine atom and bromine atom, a hydroxyl group and an alkoxy group having 1 to about 3 carbon atoms, and m is an integer of from 1 to 10.

The polymerization initiator relating to the invention includes a group of ones so called water-soluble photopolymerization initiator, and a photopolymerization initiator IRGACURE ®, manufactured by Ciba Specialty Chemicals Co., Ltd., represented by the following formula, hereinafter referred to as IC type, are usable as the photopolymerization initiator. Concretely, IC-1 to IC-3 represented by the following formulas can be used.

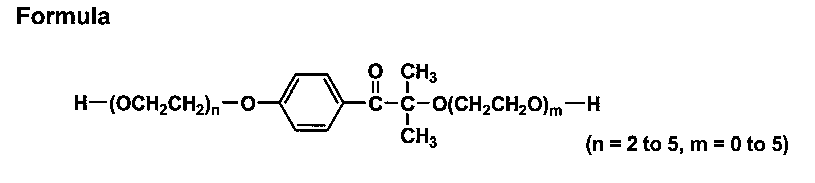

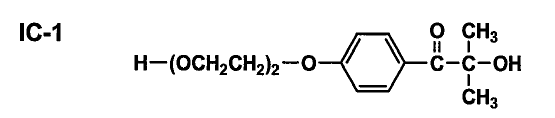

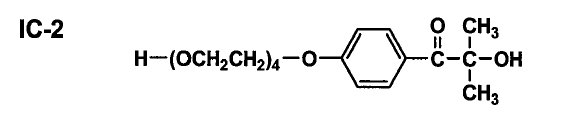

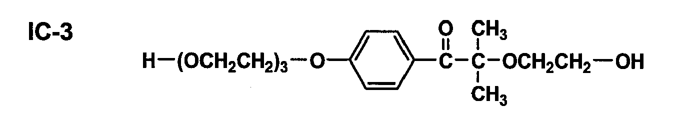

IC-1 to CI-3 are nonionic compounds and the sensitive UV wavelength range of the compounds is shorter than that of the photopolymerization initiators TX-1 to TX-3.

The mole ratio of the polymerization initiator to the compound having the addition polymerizable unsaturated bond is preferably from 1/1,000 to 1/10 though the adding amount depends on the adding amount of the compound having the addition polymerizable unsaturated bond.

The coating composition for forming the hydrophilic layer of the lithographic printing plate material of the invention comprises a material for forming a hydrophilic matrix, a filler and a matting agent for controlling the surface condition, a light-heat conversion material, and a surfactant additionally to the compound having the addition polymerizable unsaturated bond and the polymerization initiator.

In the followings, the subject of description is the material of "the coating composition for forming the hydrophilic layer of the lithographic printing plate material", and the subject is abbreviated as "hydrophilic layer" in some cases.

Material for forming a hydrophilic matrix phase is preferably a metal oxide, and more preferably metal oxide fine particles.

Examples of the metal oxide include colloidal silica, alumina sol, titania sol and another metal oxide sol. The metal oxide may have any shape such as spherical shape, feather-like shape, and the like. The average particle size is preferably 3 - 100 nm, and plural kinds of metal oxide fine particles each having a different size may be used in combination. The surface of the particles may be subjected to surface treatment.

The above-mentioned metal oxide particles can be used as a binder, utilizing its layer forming ability. The metal oxide particles are suitably used in a hydrophilic layer since they minimize lowering of the hydrophilicity of the layer as compared with an organic compound binder.

Among the above-mentioned, colloidal silica is particularly preferred in the present invention. The colloidal silica has a high layer forming ability under a drying condition with a relative low temperature, and can provide excellent layer strength.

It is preferred that the above colloidal silica is necklace-shaped colloidal silica or colloidal silica particles having an average particle size of not more than 20 nm, each being described later. Further, it is preferred that the colloidal silica provides an alkaline colloidal silica solution as a colloid solution.

The necklace-shaped colloidal silica to be used in the present invention is a generic term of an aqueous dispersion system of spherical silica having a primary particle size of the order of nm.

The necklace-shaped colloidal silica means a "pearl necklace-shaped" colloidal silica formed by connecting spherical colloidal silica particles each having a primary particle size of 10 - 50 nm so as to attain a length of 50 - 400 nm.

The term of "pearl necklace-shaped" means that the image of connected colloidal silica particles is like to the shape of a pearl necklace. The bonding between the silica particles forming the necklace-shaped colloidal silica is considered to be -Si-O-Si-, which is formed by dehydration of -SiOH groups located on the surface of the silica particles. Specific examples of the necklace-shaped colloidal silica include SNOWTEX-PS series produced by Nissan Chemical Industries, Ltd. As the products, there are SNOWTEX-PS-S (the average particle size in the connected state is approximately 110 nm), SNOWTEX-PS-M (the average particle size in the connected state is approximately 120 nm) and SNOWTEX-PS-L (the average particle size in the connected state is approximately 170 nm). Acidic colloidal silica corresponding to each of the above-mentioned is SNOWTEX-PS-SO, SNOWTEX-PS-M-O and SNOWTEX-PS-L-O, respectively.

The necklace-shaped colloidal silica is preferably used in a hydrophilic layer as a porosity providing material for hydrophilic matrix phase, and porosity and strength of the layer can be secured by its addition to the layer. Among them, the use of SNOWTEX-PS-S, SNOWTEX-PS-M or SNOWTEX-PS-L, each being alkaline colloidal silica particles, is particularly preferable since the strength of the hydrophilic layer is increased and occurrence of background contamination is inhibited even when a lot of prints are printed.

It is known that the binding force of the colloidal silica particles becomes larger with decrease of the particle size. The average particle size of the colloidal silica particles to be used in the present invention is preferably not more than 20 nm, and more preferably 3 - 15 nm. As mentioned above, the alkaline colloidal silica particles show the effect of inhibiting occurrence of the background contamination. Accordingly, the use of the alkaline colloidal silica particles is particularly preferable.

Examples of the alkaline colloidal silica particles having the average particle size within the foregoing range include SNOWTEX-20 (average particle size: 10 - 20 nm), SNOWTEX-30 (average particle size: 10 - 20 nm), SNOWTEX-40 (average particle size: 10 - 20 nm), SNOWTEX-N (average particle size: 10 - 20 nm), SNOWTEX-S (average particle size: 8 - 11 nm) and SNOWTEX-XS (average particle size: 4 - 6 nm), each produced by Nissan Chemical Industries, Ltd.

The colloidal silica particles having an average particle size of not more than 20 nm, when used together with the necklace-shaped colloidal silica as described above, is particularly preferred, since porosity of the layer is maintained and the layer strength is further increased.

The ratio of the colloidal silica particles having an average particle size of not more than 20 nm to the necklace-shaped colloidal silica is preferably 95/5 - 5/95, more preferably 70/30 - 20/80, and most preferably 60/40 - 30/70.

The porous material of a hydrophilic layer matrix in the present invention contains porous metal oxide particles having a particle diameter of less than 1 µm. Preferable examples of the porous metal oxide particles include porous silica particles, porous aluminosilicate particles or zeolite particles as described later.

The porous silica particles are ordinarily produced by a wet method or a dry method. By the wet method, the porous silica particles can be obtained by drying and pulverizing a gel prepared by neutralizing an aqueous silicate solution, or pulverizing the precipitate formed by neutralization. By the dry method, the porous silica particles are prepared by combustion of silicon tetrachloride together with hydrogen and oxygen to precipitate silica.

The porosity and the particle size of such particles can be controlled by variation of the production conditions. The porous silica particles prepared from the gel by the wet method is particularly preferred.

The porous aluminosilicate particles can be prepared by the method described in, for example, Japanese Patent O.P.I. Publication No. 10-71764. Thus prepared aluminosilicate particles are amorphous complex particles synthesized by hydrolysis of aluminum alkoxide and silicon alkoxide as the major components. The particles can be synthesized so that the ratio of alumina to silica in the particles is within the range of from 1 : 4 to 4 : 1. Complex particles composed of three or more components prepared by an addition of another metal alkoxide may also be used in the invention. In such complex particles, the porosity and the particle size can be controlled by adjustment of the production conditions.

The porosity of the particles is preferably not less than 0.5 ml/g, more preferably not less than 0.8 ml/g, and most preferably 1.0 - 2.5 ml/g, in terms of pore volume.

The pore volume is closely related to water retention of the coated layer. As the pore volume increases, the water retention is increased, contamination is difficult to occur, and the water retention latitude is broad. Particles having a pore volume of more than 2.5 ml/g are brittle, resulting in lowering of durability of the layer containing them. Particles having a pore volume of less than 0.5 ml/g may be insufficient in printing performance.

Zeolite can be employed as a porous material in the present invention. Zeolite is a crystalline aluminosilicate, which is a porous material having a regular three-dimensional network structure of orifice. Natural and synthesized zeolite is expressed by the following formula.

(M¹, M²_{1/2})ₘ(AlₘSiₙO₂₍ₘ₊ₙ₎)·xH₂O

In the above, M¹ and M² are each an exchangeable cation. Examples of M¹ include Li⁺, Na⁺, K⁺, Tl⁺, Me₄N⁺ (TMA), Et₄N⁺ (TEA), Pr₄N⁺ (TPA) and C₇H₁₅N²⁺, and examples of M² include Ca²⁺, Mg²⁺, Ba²⁺, Sr²⁺ and C₈H₁₈N²⁺. Relation of n and m is n ≥ m. Consequently, the ratio of m/n or that of Al/Si is not more than 1. A higher Al/Si ratio corresponds to a higher content of the exchangeable cation. Accordingly the polarity of the particle is raised and the hydrophilicity is also raised. The preferably Al/Si ratio is within the range of from 0.4 to 1.0, more preferably 0.8 to 1.0. x is an integer.

Synthesized zeolite having a stable Al/Si ratio and a sharp particle diameter distribution is preferably used as the zeolite particle to be used in the invention. Examples of such the zeolite include Zeolite A: Na₁₂(Al₁₂Si₁₂O₄₈)·27H₂O; Al/Si = 1.0), Zeolite X: Na₈₆(Al₈₆Si₁₀₆O₃₈₄)·264H₂O; Al/Si = 0.811 and Zeolite Y: Na₅₆(Al₅₆Si₁₃₆O₃₈₄)·250H₂O; Al/Si = 0.412.

The hydrophilicity of the hydrophilic layer itself is considerably raised by containing the porous particles having an Al/Si ratio within the range of from 0.4 to 1.0 and a high hydrophilicity, and the contamination in the course of printing is inhibited and the occurrence of contamination caused a finger mark is also considerably inhibited. When Al/Si is less than 0.4, the hydrophilicity is insufficient and the above-mentioned improving effects is lowered.

A layer structural mineral particle may be incorporated as a matrix of a hydrophilic layer of the planographic printing plate material of this invention. Examples of the layer structural mineral particle include a clayey mineral such as kaolinite, halloysite, talk, smectites such as montmorillonite, beidellite, hectorite and saponite, vermiculite, mica and chlorite, hydrotalcite and a layer structural polysilicate such as kanemite, makatite, ilerite, magadite and kenyte. Among them, ones having a higher electric charge density of the unit layer are higher in the polarity and in the hydrophilicity. Preferable charge density is not less than 0.25, more preferably not less than 0.6. Examples of the layer structural mineral having such the charge density include smectites having a negative charge density of from 0.25 to 0.6 and vermiculite having a negative charge density of from 0.6 to 0.9. Synthesized fluorinated mica is preferable since one having a stable quality, such as the particle size, is available. Among the synthesized fluorinated mica, swellable one is preferable and one freely swellable is more preferable.

An intercalation compound of the foregoing layer structural mineral such as a pillared crystal, one treated by an ion exchange treatment or surface treatment such as a silane coupling treatment and a complication treatment with an organic binder, are also usable.

The size of the flat plate-shaped layer structural mineral particle is preferably not more than 1 µm, in an average of the diameter (the largest length), and the average aspect ratio (the largest length of particle/the thickness of particle) is preferably not less than 50, in a state of contained in the layer including the case of that the particle is subjected to a swelling process and a dispersing layer-separation process. When the particle size is within the foregoing range, continuity to the parallel direction, which is a trait of the layer structural particle, and softness, are given to the coated layer so that a strong-coated layer in which a lack is difficult formed can be obtained. Sedimentation of particles can be inhibited by an effect of the thickening by the layer structural clay mineral in the coating composition containing much particle material. When the particle size is larger than the foregoing range, the scratch inhibiting effect is lowered in some cases. The scratch inhibiting effect tends also to be lowered when the aspect ratio is lower than the foregoing range since the softness of the layer is become insufficient.

The content of the layer structural clay mineral particles is preferably 0.1 - 10% by weight, and more preferably 1 - 10% by weight based on the total weight of the layer. Particularly, the addition of the swellable synthesized fluorinated mica or smectites is effective if the adding amount is small. The layer structural clay mineral particles may be added in the form of powder to a coating composition, but it is preferred that gel of the particles which is obtained by being swelled in water, is added to the coating composition in order to obtain a good dispersion ability according to an easy coating composition preparation method which requires no dispersion process comprising dispersion due to media.

The following material may be added also to the hydrophilic layer according to this invention.

An aqueous solution of a silicate is also usable. An alkali metal silicate such as sodium silicate, potassium silicate and lithium silicate are preferable, and the SiO₂/M₂O is preferably selected so that the pH value of the coating composition after addition of the silicate is within the range of not more than 13 for preventing the dissolution of the inorganic particles.

An inorganic polymer or an inorganic-organic hybrid polymer prepared by a sol-gel method can be used as a binder to be added to the hydrophilic layer. Known methods described in Sumio Sakuhana "Application of Sol-Gel Method", published by Agne Shohusha, or in the publications referred in the above publication can be applied to prepare the inorganic polymer or the inorganic-organic hybrid polymer by the sol-gel method.

A water-soluble resin may be employed. The water-soluble resin includes a polysaccharide, polyethylene oxide, polypropylene oxide, a polyvinyl alcohol, a polyethylene glycol (PEG), a polyvinyl ether, a styrene-butadiene copolymer, a conjugation diene polymer latex of methyl methacrylate-butadiene copolymer, an acryl polymer latex, a vinyl polymer latex, a polyacrylamide, and a polyvinylpyrrolidone. Among them, polysaccharide is particularly preferred as the water-soluble resin in this invention.

Starch and a derivative thereof, cellulose and a derivative thereof and a polyuronic acid are usable as polysaccharide. Among them, a cellulose derivative such as a methylcellulose salt, a carboxymethyl cellulose salt and a hydroxyethyl cellulose salt is preferable and sodium or ammonium salt of carboxymethyl cellulose is more preferable.

This is because the polysaccharides can form a preferred surface shape of the hydrophilic layer by incorporating the polysaccharide in the formed hydrophilic layer.

The surface of the hydrophilic layer preferably has an uneven structure having a pitch of from 0.1 to 20 µm such as the ground surface of the aluminum PS plate. The water holding ability and the image maintaining ability is raised by the unevenness of the surface.

The uneven structure may be formed by incorporating filler having suitable particle diameter in hydrophilic layer matrix. It is preferably formed by coating a coating composition of the hydrophilic layer containing the alkaline colloidal silica and the water-soluble polysaccharide so that the phase separation is occurred at the time of drying the coated liquid, whereby good printing performance can be obtained.

The shape of the uneven structure such as the pitch and the surface roughness thereof can be suitably controlled by the kind and the adding amount of the alkaline colloidal silica, the kind and the adding amount of the water-soluble polysaccharide, the kind and the adding amount of another additive, the solid concentration of the coating composition, the wet layer thickness and the drying condition.

In the present invention, it is preferred that the water soluble resin contained in the hydrophilic matrix phase is water soluble, and at least a part of the resin exists in the hydrophilic layer in a state capable of being dissolved in water. If a water-soluble material is cross-linked by a crosslinking agent and is insoluble in water, there may be a doubt that its hydrophilicity is lowered, resulting in problem of lowering printing performance.

A cationic resin may be contained in the layer. Examples of the cationic resin include a polyalkyleneamine or its derivative such as a polyethyleneamine and a polypropylene-polyamine, an acryl resin having a tertiary amino group or a quaternary ammonium group and diacrylamine. The cationic resin may be added in a form of a fine particle. Example of such the case is the cationic micro gel described in JP O.P.I. No. 6-161101.

A water-soluble surfactant may be added for improving the coating ability of the coating composition. A silicone type surfactant and a fluorinated surfactant are preferably used. The content of the surfactant is preferably from 0.01 to 3%, more preferably from 0.03 to 1%, by weight to the total weight of the hydrophilic layer (or total solid part weight in the coating composition).

The hydrophilic layer in the invention can contain a phosphate. Since a coating composition for the hydrophilic layer is preferably alkaline, the phosphate to be added to the hydrophilic layer is preferably sodium phosphate or sodium monohydrogen phosphate. The addition of the phosphate provides improved reproduction of dots at shadow portions. The content of the phosphate is preferably from 0.1 to 5% by weight, and more preferably from 0.5 to 2% by weight in terms of amount excluding hydrated water.

A light-to-heat conversion material may be incorporated, which is described later. A particle diameter of the light-to-heat conversion material is preferably not more than 1 µm when it is a spherical material.

It is preferred that inorganic particles or particles covered with an inorganic material having an average particle diameter of 1 µm or more are incorporated in a hydrophilic coating composition.

As for the particles to be coated, any of a porous substance, a non-porous substance, organic resin particles or inorganic particles can be used. Examples of the inorganic fillers include silica, alumina, zirconia, titania, carbon black, graphite, TiO₂, BaSO₄, ZnS, MgCO₃, CaCO₃, ZnO, CaO, WS₂, MoS₂, MgO, SnO₂, Al₂O₃, α-Fe₂O₃, α-FeO(OH), SiC, CeO₂, BN, SiN, MoC, BC, WC, titanium carbide, corundum, artificial diamond, garnet, garnet, quartz, silica rock, tripoli, diatomite, and dolomite. Examples of the organic fillers include polyethylene fine particles, fluororesin particles, guanamine resin particles, acrylic resin particles, silicone resin particles, melamine resin particles, and the like.

There are also, for example, particles in which organic particles such as particles of PMMA or polystyrene as core particles are coated with inorganic particles with a particle diameter smaller than that of the core particles. The particle diameter of the inorganic particles is preferably from 1/10 to 1/100 of that of the core particles. As the inorganic particles, particles of known metal oxides such silica, alumina, titania and zirconia can be used. Various coating methods can be used, but a dry process is preferred which core particles collide with particles for coating at high speed in air as in a hybridizer to push the particles for coating in the core particle surface and fix, whereby the core particles are coated with the particles for coating.

Particles, in which the organic core particles are plated with metal, can be used. As such particles, there is, for example, "MICROPEARL AU", produced by Sekisui Chemical Co, Ltd., in which resin particles are plated with gold.

In the invention, any fillers can be used as long as they fall within the scope of the invention. However, porous inorganic fillers such as porous silica particles or porous aluminosilicate particles or porous inorganic coated fillers are preferably used in order to prevent sedimentation thereof in the coating composition.

The particle diameter of the inorganic particles or the inorganic material-coated particles above is preferably from 1 to 12 µm, more preferably from 1.5 to 8 µm, and still more preferably from 2 to 6 µm. There is a question of lowering image definition or deterioration of blanket stain when the average particle diameter exceeds 12 µm.

The content of the particles described above with a particle diameter of not less than 1 µm in the hydrophilic layer is preferably from 1 to 50% by weight, and more preferably from 5 to 40% by weight.

It is preferable that the content ratio of the material containing carbon atom such as an organic resin or carbon black is low in view of improving hydrophilicity in the hydrophilic layer as a whole, and therefore, the whole amount of the material in the coating composition of the hydrophilic layer is preferably not more than 9 weight %, and more preferably 5 weight %.

The hydrophilic layer relating to the invention may be constituted by a single layer or plural layers and that constituted by plural layers is preferable. In such the case, the layers may be coated by once or plural times of coating. When the hydrophilic layer is composed of the plural layers, the content of the compound having the addition polymerizable unsaturated bond in the layer provided at the position further from the support is preferably from 0.5 to 50 by weight ratio to colloidal silica contained in the layer. Besides, the content of the compound having the addition polymerizable unsaturated bond in the layer provided at the position nearer to the support is preferably from 10 to 100 in weight ratio to colloidal silica contained in such the layer.

A lower layer may be provided under the hydrophilic layer provided at the nearer position from the support in an embodiment of the invention.

The materials the same as those in the hydrophilic layer can be used in the lower layer when the lower layer is provided.

However, the content of the porous material in the hydrophilic matrix of the lower layer is preferably smaller than that in the hydrophilic layer and more preferably zero since the advantage of the porosity of the lower layer is small and the strength of the layer is raised in the non-porous lower layer.

The adding amount of the inorganic particle or particle covered with the inorganic material having an average particle diameter of not less than 1 µm is preferably from 1 to 50%, and more preferably from 5 to 40%, by weight of the whole weight of the lower layer.

It is preferable for raising the hydrophilicity that the content of materials containing carbon atoms such as organic resin and carbon black is low in the lower layer similarly in the hydrophilic layer, and the sum of such the materials is preferably less than 9% and more preferably less than 5% by weight.

A hydrophilic layer, subbing layer or a thermosensitive image formation layer (abbreviated as "image formation layer"), in the present invention preferably contains a light-to-heat conversion material, and the light-to-heat conversion material is contained more preferably in a hydrophilic layer.

The hydrophilic layer may contain the following metal oxides as a light-to-heat conversion material in this invention.

Materials having black color in the visible regions or materials, which are electro-conductive or semi-conductive, can be used as light-to-heat conversion materials.

Examples of the former include black iron oxide (Fe₃O₄) and black complex metal oxides containing at least two metals.

Examples of the latter include Sb-doped SnO₂ (ATO), Sn-added In₂O₃ (ITO), TiO₂, TiO prepared by reducing TiO₂ (titanium oxide nitride, generally titanium black). Particles prepared by covering a core material such as BaSO₄, TiO₂, 9Al₂O₃·2B₂O and K₂O·nTiO₂ with these metal oxides is usable. These oxides are particles having a particle diameter of not more than 0.5 µm, preferably not more than 100 nm, and more preferably not more than 50 nm.

Black complex metal oxides containing at least two metals are more preferred among these light-to-heat conversion materials,.

Concrete examples of the black complex metal oxides include those comprising at least two selected from Al, Ti, Cr, Mn, Fe, Co, Ni, Cu, Zn, Sb, and Ba concretely. These can be prepared according to the methods disclosed in Japanese Patent O.P.I. Publication Nos. 8-27393, 9-25126, 9-237570, 9-241529 and 10-231441.

The black complex metal oxide used in the invention is preferably a complex Cu-Cr-Mn type metal oxide or a Cu-Fe-Mn type metal oxide. The Cu-Cr-Mn type metal oxides are preferably subjected to the treatment disclosed in Japanese Patent O.P.I. Publication No. 8-27393 in order to reduce isolation of a 6-valent chromium ion. These black complex metal oxides have a high color density and high light-to-heat conversion efficiency as compared with another metal oxide.

The primary average particle diameter of these black complex metal oxides is preferably not more than 1 µm, and more preferably 0.01 - 0.5 µm. The primary average particle diameter of not more than 1 µm improves light-to-heat conversion efficiency relative to the addition amount of the particles, and the primary average particle diameter of 0.01 - 0.5 µm further improves light-to-heat conversion efficiency relative to the addition amount of the particles. The light-to-heat conversion efficiency relative to the addition amount of the particles depends on a dispersibility of the particles, and the well-dispersed particles have high light-to-heat conversion efficiency. Accordingly, these black complex metal oxide particles are preferably dispersed according to a known dispersing method, separately to a dispersion liquid (paste), before being added to a coating composition for the particle containing layer. The metal oxides having a primary average particle diameter of less than 0.01 are not preferred since they are difficult to disperse. A dispersant is optionally used for dispersion. The addition amount of the dispersant is preferably 0.01 - 5% by weight, and more preferably 0.1 - 2% by weight, based on the weight of the black complex metal oxide particles.

The content of the black complex metal oxide in the hydrophilic layer is preferably from 20% by weight to less than 40% by weight, more preferably from 25% by weight to less than 39% by weight, and still more preferably from 25% by weight to less than 30% by weight, based on the total solid amount of hydrophilic layer. The content less than 20% by weight of the oxide provides poor sensitivity, while the content not less than 40% by weight of the oxide produces ablation scum due to ablation, and therefore, the above mentioned range is preferable.

The hydrophilic layer or image formation layer in the present invention can contain the following infrared absorbing dye as a light-to-heat conversion material.

Examples of the light-heat conversion material include a ordinary infrared absorbing dye such as a cyanine dye, a croconium dye, a polymethine dye, azulenium dye, a squalium dye, a thiopyrilium dye, a naphthoquinone dye and an anthraquinone dye, and an organic metal complex such as a phthalocyanine compound, a naphthalocyanine compound, an azo compound, a thioamide compound, a dithiol compound and an indoaniline compound. In concrete, the compounds described in JP O.P.I. Nos. 63-139191, 64-33547, 1-160683, 1-280250, 1-293342, 2-2074, 3-26593, 3-30991, 3-34891, 3-36093, 3-36094, 3-36095, 3-42281, 3-97589 and 3-103476. These compounds may be used singly or in combination.

The content of the infrared absorbing dye in the hydrophilic layer or the image formation layer is preferably from 0.1% by weight to less than 10% by weight, more preferably from 0.3% by weight to less than 7% by weight, and still more preferably from 0.5% by weight to less than 6% by weight, based on the total solid amount of image formation layer. As is described above, the content less than 0.1% by weight of the oxide provides poor sensitivity, while the content not less than 10% by weight of the oxide produces ablation scum due to ablation, and therefore, the above mentioned range is preferable.

An image forming layer containing a thermally fusible compound dispersed into fine particle state is preferably provided on the hydrophilic layer.

The thermally fusible compound is preferably one usually classified into wax which has particular low viscosity in the fused state among the thermoplastic materials. The melting of such the fusible compound is preferably from 60 to 100 °C. When the melting point is less than 60 °C, a problem on storage ability is posed and when that is more than 100 °C, the printing quality is lowered.

The thermally fusible compound is preferably hard at ordinary temperature and the stylus-penetrating degree defined in JIS K2207 of that is preferably less than 5% at 25 °C. When the stylus-penetration degree is not less than 5, the running durability and the resistivity to pressure fogging are lowered.

Carnauba wax, paraffin wax, montan wax, microcrystalline wax, candelilla wax and fatty acid type wax are cited as the usable materials.

Among them, one of carnauba wax, paraffin wax, microcrystalline wax, a fatty acid ester, a fatty acid amide, and a fatty acid is preferably used. Particularly, carnauba wax can be performed image formation with high sensitivity since it has relatively low melting point and low viscosity in melted state.

For using the thermally fusible compound dispersed into fine particle state, the compound is dispersed by a usually method in a medium having no dissolving ability to the compound. The compound can be held in the fine particle state after providing the image forming layer on the hydrophilic layer by drying and thermally treating at a temperature lower than the melting point of the compound.

A known thermally fusible compound particle and a thermoplastic compound particle may be contained additionally to the above thermally fusible compound in the image forming layer relating to the invention within the range in which the function of the layer is not impeded.

The image formation layer of the present invention may further contain a water-soluble material. When an image formation layer at unexposed portions is removed on a printing press employing dampening water and ink, the removal performance can be improved.

A water-soluble resin provided as a material capable of being contained in a hydrophilic layer is employed as a water-soluble material. These water-soluble resins capable of being used for an image formation layer in the present invention can be selected from hydrophilic natural polymers and synthetic polymers. Specific examples of the water-soluble resin which are preferably used in the present invention include natural polymers such as gum arabic, water-soluble soybean polysaccharides, cellulose derivatives (such as carboxymethyl cellulose, carboxyethyl cellulose, methylcellulose and the like, for example), there modified products, white dextrin, pullulan, enzymolysis etherified dextrin and the like, as well as synthetic polymers such as polyvinyl alcohol (preferably with a saponification degree of not less than 70% by mol), polyacrylic acid, its alkaline metal salt or its amine salt, polyacrylic acid copolymer, its alkaline metal salt or its amine salt, polymethacrylic acid, its alkaline metal salt or its amine salt, vinyl alcohol-acrylic acid copolymer, its alkaline metal salt or its amine salt, polyacrylamide, its copolymer, polyhydroxyethyl acrylate, polyvinyl pyrrolidone, its copolymer, polyvinylmethyl ether, vinylmethyl ether-maleic acid anhydride copolymer, poly-2-acrylamide-2-methyl-1-propane sulfonic acid, its alkaline metal salt or its amine salt, poly-2-acrylamide-2-methyl-1-propane sulfonic acid copolymer, its alkaline metal salt or its amine salt and the like. These can also be used in admixture combination with two kinds or more. The present invention is not restricted to these examples.

The content of water-soluble resin in the image formation layer is preferably 1 - 50% by weight, and more preferably 2 - 10% by weight based on the total layer weight.

The image exposure is preferably scanning exposure, which is carried out employing a laser which can emit light having a wavelength of infrared and/or near-infrared regions, that is, a wavelength of 700 - 1500 nm. As the laser, a gas laser can be used, but a semi-conductor laser, which emits light having a near-infrared region wavelength, is preferably used.

A device suitable for the scanning exposure may be any device capable of forming an image on the printing plate material according to image signals from a computer employing the semi-conductor laser. Generally, the following scanning exposure processes are mentioned.
(1) A process in which a plate precursor provided on a fixed horizontal plate is scanning exposed in two dimensions, employing one or several laser beams.
(2) A process in which the surface of a plate precursor provided along the inner peripheral wall of a fixed cylinder is subjected to scanning exposure in the rotational direction (in the main scanning direction) of the cylinder, employing one or several lasers located inside the cylinder, moving the lasers in the normal direction (in the sub-scanning direction) to the rotational direction of the cylinder.
(3) A process in which the surface of a plate precursor provided along the outer peripheral wall of a fixed cylinder is subjected to scanning exposure in the rotational direction (in the main scanning direction) of the cylinder, employing one or several lasers located inside the cylinder, moving the lasers in the normal direction to the rotational direction of the cylinder (in the sub-scanning direction).

In the present invention, the process (3) above is preferable, and especially preferable when a printing plate material mounted on a plate cylinder of a printing press is scanning exposed.

In the printing plate material of the present invention, it is preferred that at least one backing layer is provided on the surface of the support opposite the image formation layer, in order to improve handling properties and minimize change in physical properties during storage. It is preferred that a backing layer contains a hydrophilic binder, and the hydrophobic binder may be water dispersible resins disclosed in Japanese Patent O.P.I. Publication No. 2002-258469, paragraphs 0033 through 0038, as long as it can make the surface of the printing plate material hydrophobic.

The hydrophilic binder is not particularly restricted as long as it exhibits hydrophilicity, and examples of the hydrophilic binder include resins having, as a hydrophilic group, a hydroxyl group such as polyvinyl alcohol (PVA), cellulose resins (such as methylcellulose (MC), ethyl cellulose (EC), hydroxyethyl cellulose (HEC), carboxymethylcellulose (CMC)), chitins, or starch; resins having an ether bond such as polyethylene oxide (PEO), polypropylene oxide (PPO), polyethylene glycol (PEG), or polyvinyl ether (PVE); resins having an amide group or an amide bond such as polyacryl amide (PAAM) or polyvinyl pyrrolidone (PVP); resins having as a dissociation group a carboxyl group such as polyacrylic acid salts, maleic acid resins, alginates or gelatins; polystyrene sulfonic acid salt; resins having an amino group, an imino group, a tertiary amino group or a quaternary ammonium group such as polyallylamine (PAA), polyethylene imine (PEI), epoxidated polyamide (EPAM), polyvinyl pyridine or gelatins.

The hydrophobic binder may be any as long as it exhibits hydrophobicity, and examples of the hydrophobic binder include polymers derived from α,β-ethylenically unsaturated monomers such as polyvinyl chloride, chlorinated polyvinyl chloride, a copolymer of vinyl chloride and vinylidene chloride, a copolymer of vinyl chloride, and vinyl acetate, polyvinyl acetate, partially saponified polyvinyl acetate, polyvinyl acetal or preferably polyvinyl butyral in which a part of polyvinyl alcohol is acetalized with aldehyde, a copolymer of acrylonitrile and acryl amide, polyacrylates, polymethacrylates, polystyrene, polyethylene and a mixture thereof.

It is preferred that the backing layer contains a matting agent, in order to easily mount the printing plate on a printing press and to prevent "out of color registration" due to "out of registration" of the printing plate during printing. As the matting agent, a porous or non-porous matting agent or an organic or inorganic matting agent can be used. Examples of the inorganic matting agent include silica, alumina, zirconia, titania, carbon black, graphite, TiO₂, BaSO₄, ZnS, MgCO₃, CaCO₃, ZnO, CaO, WS₂, MoS₂, MgO, SnO₂, Al₂O₃, α-Fe₂O₃, α-FeO(OH), SiC, CeO₂, BN, SiN, MoC, BC, WC, titanium carbide, corundum, artificial diamond, garnet, garnet, quartz, silica rock, triboli, diatomite, and dolomite. Examples of the organic matting agent include polyethylene fine particles, fluororesin particles, guanamine resin particles, acrylic resin particles, silicone resin particles, melamine resin particles, and the like. As the inorganic material coated fillers, there are, for example, particles in which organic particles such as particles of PMMA or polystyrene as core particles are coated with inorganic particles with a particle diameter smaller that that of the core particles. The particle diameter of the inorganic particles is preferably 1/10 - 1/100 of that of the core particles. As the inorganic particles, particles of known metal oxides such silica, alumina, titania and zirconia can be used. Various coating methods can be used, but a dry process is preferred which core particles collide with particles for coating at high speed in air as in a hybridizer to push the particles for coating in the core particle surface and fix, whereby the core particles are coated with the particles for coating.

In the case of a planographic printing plate material in the form of roll, the matting agent in the back coat layer is preferably organic resin particles in minimizing scratches on the image formation layer surface. The average particle diameter of the matting agent in the present invention is determined in terms of an average diameter of circles having the same area as projected images of the particles photographed by means of an electron microscope. The average particle diameter of the matting agent is preferably 1 - 12 µm, more preferably 1.5 - 8 µm, and still more preferably 2 - 7 µm. In the case of the particle diameter exceeding 12 µm, scratches on the image formation layer can be easily generated, and in the case of a particle diameter of 1 µm, fixation of a planographic printing plate material is also generated to a plate cylinder.

The matting agent content is preferably 0.2 - 30% by weight, and more preferably 1 - 10% by weight, based on the total back coat layer weight.

A laser recording apparatus or a processless printing press has a sensor for controlling transportation of the printing plate material. In the present invention, in order to carry out the controlling smoothly, the structural layer preferably contains dyes or pigment. The dyes or pigment are preferably infrared absorbing dyes or pigment as described above used as a light-to-heat conversion material. The structural layer can further contain a known surfactant.

Materials for the support in the present invention are preferably plastic films. Examples thereof include polyethylene terephthalate (PET), polyethylene naphthalate (PEN), polyimide, polyamide, polycarbonate, polysulfone, polyphenylene oxide, and cellulose ester. Of these, PET and PEN of polyester are and further PET is particularly preferable, in view of a handling property and so forth.

PET is composed of terephthalic acid and ethylene glycol, and PEN is also composed of naphthalene dicarboxylic acid and ethylene glycol. These are combined via polycondensation under the appropriate reaction condition employing a catalyst. In this case, one or more kinds of a third component may be appropriately mixed. The third component may be a functional compound capable of forming ester, and examples of dicarboxylic acid can be provided as shown below.

As a dicarboxylic acid, there is, for example, isophthalic acid, phthalic acid, 2,6-naphthalene dicarboxylic acid, 2,7-naphthalene dicarboxylic acid, diphenylsulfone dicarboxylic acid, diphenylether dicarboxylic acid, diphenylethane dicarboxylic acid, cyclohexane dicarboxylic acid, diphenyl dicarboxylic acid, diphenylthioether dicarboxylic acid, diphenylketone dicarboxylic acid, or diphenylindane dicarboxylic acid. As a glycol, there is, for example, ethylene glycol, propylene glycol, tetramethylene glycol, cyclohexanedimethanol, 2,2-bis(4-hydroxyphenyl)propane, 2,2-bis(4-hydroxyethoxyphenyl)propane, bis(4-hydroxyphenyl)-sulfone, bisphenol fluorene dihydroxyethyl ether, diethylene glycol, neopentylene glycol, hydroquinone, or cyclohexane diol.

The intrinsic viscosity of PET resin in the present invention is preferably 0.5 - 0.8. PET resins having different viscosity may be used as an admixture.

A synthesis method of PET of the present invention is not specifically limited, and PET can be manufactured according to a conventional manufacturing method. As the manufacturing method, there is a direct esterification method in which a dicarboxylic acid component is directly reacted with a diol component, or an ester exchange method in which dialkylester is first employed as dicarboxylic acid, and this one and the diol component are polymerized via the ester exchange reaction by heat application to be esterified while removing the extra diol under reduced pressure. In this case, an ester exchange catalyst, a polymerization catalyst or a heat-resistant stabilizer can be added. Examples of the heat stabilizer include phosphoric acid, phosphorous acid, and ester compounds thereof. During synthesis, an anti-stain agent, a crystal nucleus agent, a slipping agent, a stabilizer, an anti-blocking agent, a UV absorber, a viscosity adjusting agent, a transparentizing agent, an anti-static agent, a pH adjusting agent, a dye or pigment may be added.

Next, a manufacturing method of the planographic printing plate material in the present invention will be described.

A method of preparing an unstretched sheet and a sheet which is uniaxially stretched in the longitudinal direction can be a commonly known method. Polyester as a raw material is molded in the form of pellets, and after a hot-air drying process or a vacuum drying, they are melted and extruded in the form of sheets by a T-shaped die. Subsequently, they are attached firmly onto a cooling drum and cooled rapidly to obtain an unstretched sheet. Next, the resulting unstretched sheet is heated in the range of from the glass transition temperature (Tg) to Tg + 100 °C via plural rollers and/or heating apparatuses such as an infrared heater and the like to be stretched in the longitudinal direction. The stretching magnification is usually 2.5 - 6.

In this case, a roll-set curl can be avoided by arranging a stretching temperature difference between both surfaces of a support. Specifically, temperature can be controlled by providing a heating apparatus such as an infrared heater or such on one surface side during heating while stretching in the longitudinal direction. The temperature difference at the time of stretching is preferably 0 - 40 °C, and more preferably 0 - 20 °C. In the case of the temperature difference exceeding 40 °C, it is not preferable that film sheet flatness is degraded because of uneven stretching.

Next, the resulting polyester film sheet which is uniaxially stretched in the longitudinal direction is stretched in the transverse direction in the temperature range of from Tg to Tg + 120 °C, and subsequently fixed by heat. The transverse stretching magnification is usually 3 - 6, and the ratio of longitudinal and transverse stretching magnifications is appropriately adjusted so as to have a preferable property via measuring of properties of the resulting biaxially stretching film sheet. As to heat fixation, a heat fixation process is usually conducted in the temperature range of not more than Tg + 180 °C, which is higher than the final transverse stretching temperature, for 0.5 - 300 sec. In this case, film sheets are preferably heat fixed with two or more temperatures. Dimension stability of the film sheets heat fixed with such the two or more temperatures is improved, whereby a support can usefully be provided for the printing plate material.

The support for the printing plate material in the present invention is preferably subjected to relaxation treatment in view of dimension stability. The relaxation treatment can preferably be conducted before a roll-up process in a tenter for stretching in the transverse direction or in the exterior of the tenter after heat fixing in the stretching process of the foregoing polyester film sheet. The relaxation treatment is preferably carried out in a temperature of 80 - 200 °C, and more preferably 100 - 180 °C. The relaxation treatment is also carried out preferably in a rate of 0.1 - 10% in both longitudinal and transverse directions, and more preferably in a rate of 2 - 6%.

Particles having a size of 0.01 - 10 µm are preferably incorporated in an amount of 1 - 1,000 ppm into the support, in improving handling property. Herein, the particles may be organic or inorganic material. Examples of the inorganic material include silica described in Swiss Patent 330158, glass powder described in French Patent 296995, and carbonate salts of alkaline earth metals, cadmium or zinc described in British Patent 1173181. Examples of the organic material include starch described in U.S. Patent 2,322,037, starch derivatives described such as in Belgian Patent 625451 and British Patent 981198, polyvinyl alcohol described in Japanese Patent Examined Publication No. 44-3643, polystyrene or polymethacrylate described in Swiss Patent 330158, polyacrylonitrile described in U.S. Patent 3,079,257 and polycarbonate described in U.S. Patent 3,022,169. The shape of the particles may be in a regular form or irregular form.

The support in the present invention has a coefficient of elasticity of preferably 300 - 800 kg/mm², and more preferably 400 - 600 kg/mm², in view of the above handling property. The coefficient of elasticity herein referred to is a slope of the straight line portion in the stress-strain diagram showing the relationship between strain and stress, which is obtained employing a tension test meter according to JIS C2318. This slope is called Young's modulus. In the present invention, it is defined that the foregoing Young's modulus is the coefficient of elasticity.

The support in the present invention has an average thickness of preferably in the range between 100 and 500 µm, and a thickness dispersion of preferably not more than 5%, in that a handling property is improved when the foregoing printing plate material is mounted on a press. The average thickness of the support is most preferably 120 - 300 µm, and the thickness dispersion of the support is most preferably not more than 2%. The thickness dispersion of the support is determined according to the following: lines are formed at an interval of 10 cm in both the transverse and longitudinal directions on a 60 cm square polyester film sheet to form 36 small squares. The thicknesses of the 36 small squares are measured, and the average thickness, maximum thickness and minimum thickness are obtained.

The plastic support of the present invention may be subjected to heat treatment to reduce the roll-set curl. Provided as the heat treating method are a method of heat treating before and after rolling up in the form of roll after coat drying of each structural layer of the printing plate material, and also a method of heat treating by using a transport line during coat drying.

As a method of heat treating in the form of roll, there is a method of heat treating at a temperature below the glass transition temperature for 0.1 - 1,500 hours after preparing a polyester support, as described in Japanese Patent O.P.I. Publication No. 51-16358. In this case, it is preferred to conduct processes such as a process of embossing at the film edge and center portion partially or over the entire length of the film sheet, a process of bending at the edge, and a process of thickening the film thickness partially in view of a film-to-film anti-blocking. It is preferable that sufficient strength is arranged to such an extent that no film rolling deflection occurs, and material quality and structure capable of being resistant to the heat treating temperature in order to avoid deformation caused by the roll core transfer.

As for a method of heat treatment by using a transport line, the roll-set curl can be minimized by heat treating while transporting a zone having a temperature slope between a glass transition temperature and not less than the glass transition temperature, as described in Japanese Patent O.P.I. Publication No. 10-39448. Though a longer period of time is preferred for heat treatment, it is preferred to heat treat while transporting in CS: 5 - 50 m/min in view of productivity as well as transportability. Transport tension is not particularly specified, but a transport tension of 5 - 60 kg/m is preferred. In the case of heat treatment via avoiding the above-mentioned range of CS and transport tension, it is not preferred that roll wrinkles are generated, and support surface flatness is degraded. When heat treating in the line transport, provided are a transport method in which a film sheet is transported while holding the film sheet in a state of surface flatness, a transport method employing a pin or a clip, air transport method, a roller transport method, and so forth. Of these, air transport method and a roller transport method are preferably used, and a roller transport method is more preferably used.

A plastic film support is employed as a support in the present invention, but a composite material support in which plastic film sheets are appropriately laminated with metal plates (iron, stainless steel, aluminum, an the like) or paper sheet material covered by polyethylene (referred to as composite material) can be used. This composite material may be laminated prior to or after forming a coated layer, and also just before mounting on a printing press.

It is preferred in the present invention that a subbing layer is formed between a plastic support and a hydrophilic layer. The subbing layer is preferably composed of two layers. It is preferable that material adhering to the plastic support is employed on the plastic support side (lower subbing layer), and material adhering between the hydrophilic layer and the lower subbing layer is used on the hydrophilic layer side.

Examples of the material employed as a lower subbing layer include vinyl polymer, polyester, styrene, or styrene-diolefin. Vinyl polymer and polyester are particularly preferable, or it is preferred that these are used in combination or in modification.

On the other hand, the material employed as an upper subbing layer preferably contains a water-soluble polymer in view of improved adhesion to the hydrophilic layer, and it is preferable that the water-soluble polymer, in which gelatin or a polyvinyl alcohol unit is a major component, is specifically used. It is preferable that these are mixed with the material used as a lower subbing layer and the above-mentioned water-soluble polymer in view of adhesion to the lower subbing layer as well as to the hydrophilic layer.

It is preferable that a water-soluble polymer containing a polyvinyl alcohol unit as a major component (polyvinyl alcohol series polymer), is contained in a hydrophilic layer, and adhesion between the plastic support and the hydrophilic layer can be improved by containing a water-soluble polymer, in which a polyvinyl alcohol unit is a major component, in a lower subbing layer, whereby printing plate material exhibiting excellent on-press development and printing durability can also be obtained.

Next, each material which is usable for subbing layers will be explained.

### (POLYESTER)

A substantively linear polyester resin obtained via a polycondensation reaction of polybasic acid or its ester, and either polyol or its ester, is used as polyester. Further in the case of being used in the water-soluble form, employed is polyester into which an example of a component having a hydrophilic group including a sulfonate-containing component, a diethylene glycol component, a polyalkylene ether glycol component, or a polyether dicarboxylic acid component is introduced as a copolymerization component. Sulfonate-containing dicarboxylic acid (dicarboxylic acid is hereinafter referred to as polybasic acid) is preferably employed as a component having a hydrophilic group.

Examples employed as a polyester polybasic acid component include terephthalic acid, isophthalic acid, phthalic acid, phthalic anhydride, 2, 6-naphthalene dicarboxylic acid, 1, 4-cyclohexane dicarboxylic acid, adipic acid, sebacic acid, trimellitic acid, pyromellitic acid, dimer acid, maleic acid, fumaric acid, itaconic acid, p-hydroxybenzoic acid, and p-(β-hydroxy ethoxy) benzoic acid. A component having sulfonic-acid alkaline metal salt is preferably used as the above sulfonate-containing dicarboxylic acid. Alkaline metal salt of 4-sulfoisophthalic acid, 5-sulfoisophthalic acid, sulfoterephthalic acid, 4-sulfophthalic acid, 4-sulfonaphthalene-2, 7-dicarboxylic acid, and 5-(4-sulfophenoxy) isophthalic acid are provided as examples. Of these, 5-sulfoisophthalic acid sodium salt is especially preferred. It is preferred from the aspect of water solubility and water resistance that the content of the dicarboxylic acid having a sulfonate is 5 - 15 mol%, based on the total dicarboxylic acid component, but is more preferably 6 - 10 mol%. A major dicarboxylic acid component having terephthalic acid and isophthalic acid is preferably used as water-soluble polyester, and it is further especially preferred, from the aspect of coatability and water solubility of a polyester support, that the content ratio of terephthalic acid and isophthalic acid is 30/70 - 70/30 in mol%. The content of these terephthalic acid and isophthalic acid components is preferably 50 - 80 mol%, based on the total dicarboxylic acid component, and it is further preferred that an alicyclic dicarboxylic acid is employed as a polymerization component. Examples provided as the alicycle dicarboxylic acid include 1, 4-cyclohexane dicarboxylic acid, 1, 3-cyclohexane dicarboxylic acid, 1, 2-cyclohexane dicarboxylic acid, 1, 3-cyclopentane dicarboxylic acid, and 4, 4'-bicyclo hexyl dicarboxylic acid. Dicarboxylic acid other than the above dicarboxylic acids can also be used as a copolymerization component for the water-soluble polyester of the present invention containing terephthalic acid and isophthalic acid as the dicarboxylic acid component. Examples provided as the dicarboxylic acid include aromatic dicarboxylic acid and straight-chained aliphatic dicarboxylic acid. The aromatic dicarboxylic acid is preferably used in the range of not more than 30 mol%, based on the total dicarboxylic acid component. Examples provided as the aromatic dicarboxylic acid include phthalic acid, 2, 5-dimethyl terephthalic acid, 2, 6-naphthalene dicarboxylic acid, 1, 4-naphthalene dicarboxylic acid, and biphenyl dicarboxylic acid. Straight-chained aliphatic dicarboxylic acid is preferably used in the range of not more than 15 mol%, based on the total dicarboxylic acid component. Examples provided as the straight-chained aliphatic dicarboxylic acid include adipic acid, pimelic acid, suberic acid, azelaic acid, and sebacic acid.

Examples employed also as a polyol component include ethylene glycol, diethylene glycol, 1,4-butanediol, neopentylglycol, dipropylene glycol, 1,6-hexanediol, 1, 4-cyclohexanedimethanol, xylylene glycol, trimethylolpropane, poly ethylene oxide glycol, and poly tetramethylene oxide glycol.

Ethylene glycol, in the range not less than 50 mol%, is preferably used as a glycol component of the water-soluble polyester, based on the total glycol component.

Polyester can be synthesized, employing either dicarboxylic acid or its ester, and either glycol or its ester, as the starting raw material, for which various methods can be employed to synthesize it. An initial condensed material of dicarboxylic acid and glycol, for example, is formed by an ester exchange method or a direct esterification method, and further the polyester resin can be acquired by a commonly known manufacturing method via melt-polymerization of the initial condensation material. As more specific examples, provided are methods such as a method of conducting a polycondensation process under high vacuum by decreasing pressure gradually after ester exchange reaction is conducted with ester of dicarboxylic acid which is, for example, dimethylester of dicarboxylic acid, and glycol, whereby methanol is distilled, a method of conducting a polycondensation process under high vacuum by gradually decreasing pressure after esterification reaction is conducted with dicarboxylic acid and glycol, whereby produced water is distilled, and also a method of conducting a polycondensation process under high vacuum after conducting esterification reaction by adding dicarboxylic acid. A commonly known catalyst can be employed as an ester exchange catalyst or a polycondensation catalyst. Examples used as the ester exchange catalyst include manganese acetate, calcium acetate, and zinc acetate. Examples used as the polycondensation catalyst include antimony trioxide, germanium oxide, dibutyl tin oxide, and titanium tetrabutoxide. Various conditions of processes and components including polymerization and catalyst, however, are not limited to the above examples.

### (VINYL POLYMERS)

Provided as vinyl polymer in the present invention, for example, are acryl-containing monomers such as alkyl acrylate or alkyl methacrylate (the alkyl group such as methyl group, ethyl group, n-propyl group, isopropyl group, n-butyl group, isobutyl, t-butyl group, 2-ethylhexyl group, cyclohexyl group, phenyl group, benzyl group, or phenylethyl group); hydroxy group-containing monomers such as 2-hydroxyethyl acrylate, 2-hydroxyethyl methacrylate, 2-hydroxypropyl acrylate, or 2-hydroxypropyl methacrylate; amide group-containing monomer such as acrylamide, methacrylamide, N-methyl methacrylamide, N-methyl acrylamide, N-methylol acrylamide, N-methylol methacrylamide, N, N-dimethylol acrylamide, N-methoxymethyl acrylamide, N-methoxymethyl methacrylamide, or N-phenyl acrylamide; amino group-containing monomers such as N, N-diethylaminoethyl acrylate, or N, N-diethyl aminoethyl methacrylate; epoxy group-containing monomers such as glycidyl acrylate, or glycidyl methacrylate; and carboxyl group or its salt-containing monomer such as acrylic acid, methacrylic acid, or its salt (such as sodium salt, potassium salt, or ammonium salt). As monomers other than acryl-containing monomers, provided, for example, are epoxy group-containing monomers such as allyl glycidyl ether, and others; sulfonic acid group or its salt-containing monomers such as styrene sulfonic acid, vinyl sulfonic acid, and its salt (such as sodium salt, potassium salt, or ammonium salt); carboxyl group or its salt-containing monomers such as crotonic acid, itaconic acid, maleic acid, fumaric acid, and its salt (such as sodium salt, potassium salt, or ammonium salt); acid anhydride-containing monomer such as maleic anhydride, or itaconic acid anhydride; vinyl isocyanate; allyl isocyanate; styrene; vinyl tris alkoxy silane; alkyl maleic acid monoester; alkyl fumaric acid monoester; acrylonirile; methacrylonitrile; alkyl itaconic acid monoester; vinylidene chloride; vinyl acetate; and vinyl chloride. Epoxy group-containing monomers such as glycidyl acrylate, and glycidyl methacrylate are preferably used as a vinyl system monomer from the aspect of coated layer strength.

The vinyl polymer in the present invention is preferably polymer latex in view of environmental considerations. The polymer latex refers to a polymer component which is dispersed in water or a water-soluble medium as water-insoluble hydrophobic polymer minute particles. Each of dispersion states may be any of the following states: the polymer is emulsified in a dispersion medium in a dispersed state; the polymer is formed employing emulsion polymerization; the polymer is subjected to micelle dispersion; or the polymer has a partial hydrophilic structure in the molecule, and the molecular chain itself is subjected to molecular dispersion. Incidentally, examples of polymer latexes in the present invention are described in "Gosei Jushi Emulsion (Synthetic Resin Emulsion)", edited by Taira Okuda and Hiroshi Inagaki, published by Kobunshi Kankokai (1978); "Gosei Latex no Oyo (Application of Synthetic Latexes)", edited by Takaaki Sugimura, Yasuo Kataoka, Soichi Suzuki, and Keiji Kasahara, published by Kobunshi Kankokai (1993); and "Gosei Latex no Kagaku (Chemistry of Synthetic Latexes)", edited by Soichi Muroi, published by Kobunshi Kankokai (1970).

The average particle size of polymer latex dispersing particles is 1 - 50,000 nm, and more preferably 5 - 1,000 nm. The particle size distribution thereof may be a polydispersed or a monodispersed distribution.

The vinyl polymer latexes of the present invention may be those having a uniform structure or may be core/shell type polymer latexes. In this case, the core and shell tend to be preferably used when glass transition temperature varies.

The minimum film forming temperature (MFT) of the vinyl polymer latexes in the present invention is preferably -30 °C to 90 °C, and more preferably 0 °C to 70 °C. A film forming aid may be added to control the MFT. The film forming aid is also called a plasticizer, which is an organic compound (conventionally, an organic solvent) capable of lowering the MFT of a polymer latex, and is described in "Chemistry of Synthetic Latex" (Soichi Muroi, published by KOBUNSHI-KANKOKAI, 1970).

### (POLYMER HAVING VINYL ALCOHOL UNIT)

The polymer having vinyl alcohol unit, employed for a subbing layer, will be described.

In the present invention, provided as the polymer having vinyl alcohol unit are polyvinyl alcohol and its derivative such as ethylene copolymerized polyvinyl alcohol, modified polyvinyl alcohol dissolved in water via partial butyral treatment, and so forth.

Polyvinyl alcohol preferably has a polymerization degree of not less than 100 and a saponification degree of not less than 60, and as its derivative, polymer having a monomer unit exemplarily represents vinyl compounds such as ethylene propylene and the like as a copolymerization component of vinyl acetate before saponification, acrylic acid esters (for example, t-butylacrylate, phenylacrylate, 2-naphthylacrylate, etc.), methacrylic acid esters (for example, methylmethacrylate, ethylmethacrylate, 2-hydroxyethylmethacrylate, benzylmethacrylate, 2-hydroxypropylmethacrylate, phenylmethacrylate, cyclohexylmethacrylate, cresylmethacrylate, 4-chlorobenzylmethacrylate, ethyleneglycoldimethacrylate, etc.), acrylamides (for example, acrylamide, methylacrylamide, ethylacrylamide, propylacrylamide, butylacrylamide, tert-butylacrylamide, cyclohexylacrylamide, benzylacrylamide, hydroxymethylacrylamide, methoxyethylacrylamide, dimethylaminoethylacrylamide, phenylacrylamide, dimethylacrylamide, diethylacrylamide, β-cyanoethylacrylamide, diacetoneacrylamide, etc.), methacrylamides (for example, methacrylamide, methylmethacrylamide, ethylmethacrylamide, propylmethacrylamide, butylmethacrylamide, tert-butylmethacrylamide, cyclohexylmethacrylamide, benzylmethacrylamide, hydroxymethylmethacrylamide, methoxyethylmethacrylamide, dimethylaminoethylmethacrylamide, phenylmethacrylamide, dimethylmethacrylamide, diethylmethacrylamide, β-cyanoethylmethacrylamide, etc.), styrenes (for example, styrene, methylstyrene, dimethylstyrene, trimethylstyrene, ethylstyrene, iso-propylstyrene, methoxystyrene, acetoxystyrene, chlorostyrene, dichlorostyrene, bromostyrene, vinylbenzoic acid methyl ester, etc.), divinylbenzene, acrylonitrile, methacrylonitrile, N-vinylpyrrolidone, N-vinyloxazolidone, vinylidene chloride, phenylvinylketone, etc. Of these, ethylene copolymerized polyvinyl alcohol is preferably employed. The content of polymer containing a polyvinyl alcohol unit in an upper subbing layer is 1 - 50% by weight, based on the total binder of the upper subbing layer, and preferably 5 - 10% by weight. In the case of less than 1%, no effect is observed, and In the case of not less than 50%, it is not preferable to result in enhanced hydrophilicity and to exhibit degraded printing durability at high humidity.

### (OTHERS)

The following inorganic particles can be employed for the subbing layer in the present invention. Examples of the inorganic material include silica, alumina, barium sulfate, calcium carbonate, titania, tin oxide, indium oxide, and talk. These particle shapes are not particularly limited, and any shape such as needle-like, spherical, plate-like, or fracture-like shape can be used. The particle diameter is preferably 0.1 - 15 µm, more preferably 0.2 - 10 µm, and still more preferable 0.3 - 7 µm. The addition amount of particles is 0.1 - 50 mg per 1 m² of one surface, preferably 0.2 - 30 mg, and more preferably 0.3 - 30 mg.

In the present invention, thickness of the subbing layer is preferably 0.05 - 0.50 µm in view of transparency and uneven coating (interference unevenness), and more preferably 0.10 - 0.30 µm. It is not preferred because sufficient adhesion property is not obtained and property of on-press development, printing shear and durability deteriorate when not more than 0.05 µm. It is not preferable in market value because of interference uniformity when more than 0.50 µm.

As for the subbing layer, the coating composition is coated onto either one surface or both surfaces of polyester film particularly before completing crystalline orientation during coating of a support, but it is preferable that the coating composition is coated onto either one surface or both surfaces of polyester film in on line or off line after coating of a support.

As a coating method of the subbing layer, commonly known as appropriate coating-methods may be employed. It is preferable to apply the following method singly or in combination, for example, a kiss coating method, reverse coating method, die coating method, reverse kiss coating method, offset gravure coating method, the Meyer bar coating method, roller brush method, spray coating method, air-knife coating method, dip-coating method, and curtain coating method.

It is preferable to provide an antistatic layer for the subbing layer. The antistatic layer is composed of an antistatic agent and a binder.

A metal oxide is preferably employed as an antistatic agent. Examples of such metal oxides preferably include ZnO, TiO₂, SnO₂, Al₂O₃, In₂O₃, SiO₂, MgO, BaO, MoO₂, and V₂O₅, as well as their multiple oxides. Specifically, from the viewpoint of miscibility with a binder, electrical conductivity and transparency, SnO₂ (tin oxide) is preferred. As examples containing a different atom, Sb, Nb, or a halogen atom may be added to SnO₂. The added amount of the different atom is preferably in the range of 0.01 - 25 mol%, but the range of 0.1 - 15 mol% is specifically preferred.

Above described tin oxide is preferably in the form of an amorphous sol or crystalline particles. In the case of water based coating, an amorphous sol is preferred, and in the case of a solvent based coating, it is in the form of crystalline particles. Specifically, from the viewpoint of ecology and handling during operation, the amorphous sol form of water based coating is preferred.

A production method of the amorphous SnO₂ sol utilized for the present invention may be either of the following methods, a method to prepare by dispersing SnO₂ particles into an appropriate solvent, or a method to prepare via decomposition reaction of a solvent-soluble Sn compound in a solvent. The preparation via a decomposition reaction of a solvent-soluble Sn compound in the solvent will be described. The solvent-soluble compound means a compound containing an oxo-anion such as K₂SnO₃·3H₂O, water-soluble halide compound such as SnCl₄ or a compound having a structure represented by R'₂SnR₂, R₃SnX or R₂SnX₂ including, for example, organometallic compound such as (CH₃)₃SnCl·(pyridine), (C₄H₉)₂Sn(O₂CC₂H₅)₂ and an oxo-salt such as Sn(SO₄)₂·2H₂O. Methods for preparing a SnO₂ sol using the solvent-soluble Sn compound include a physical method by dissolving in a solvent, followed by applying heat or pressure, chemical method by oxidation, reduction or hydrolysis, and a method of preparing a SnO₂ sol via an intermediate. A SnO₂ sol preparation method described in Japanese Patent Examined Publication No. 35-6616 will be described as an example. SnCl₄ is first dissolved in distilled water of 100 times in capacity, and a precipitate of Sn(OH)₄ is prepared as an intermediate. Ammonia water is added into this product so as to be mildly alkaline, and colloidal SnO₂ sol can be prepared subsequently by heating up until ammonia odor does not smell at all. In addition, provided can be various solvents used for Sn compounds including an alcohol solvent such as methanol, ethanol, or isopropanol, an ether solvent such as tetrahydrofuran, dioxane, or diethylether, an aliphatic organic solvent such as hexane or heptane, and an aromatic organic solvent such as benzene or pyridine, though water is employed as a solvent in the example. The present invention is not limited to solvents, but solvents of water and alcohols are preferably selected.

On the other hand, crystalline particles are described in detail in Japanese Patent O.P.I. Publication Nos. 56-143430 and 60-258541. Production methods of these electrically conductive metal oxide particles may be any one of the following methods or a combination of them. The first method is one in which metal oxide particles are prepared by baking, after which the particles are heat treated under the presence of different kinds of atoms; the second is that different kinds of atoms are presented during preparation of metal oxide particles while baking; and the third being oxygen defect is introduced by a decrease of oxygen concentration during baking.

The average particle diameter of the primary particles employed in the present invention is 0.001 - 0.5 µm, but preferably 0.001 - 0.2 µm. The solid content coverage of the metal oxide employed in this invention is 0.05 - 2 g, but preferably 0.1 - 1 g. Further, the volume fraction of metal oxide in the antistatic layer of this invention is 8 - 40% by volume, but preferably 10 - 35% by volume. The above range may vary due to color, form and composition of metal oxide particles, but in view of transparency and electrical conductivity, the above range is preferred.

On the other hand preferable examples of binder also include polyester, acryl modified polyester, polyurethane, acryl resin, vinyl resin, vinylidene chloride resin, polyethylene imine vinylidene resin, polyethylene imine, polyvinyl alcohol, modified polyvinyl alcohol, cellulose ester and gelatin.

### EXAMPLES

The invention is described bellow referring examples, but the invention is not limited to the examples.

### Example 1

### (Preparation of support)

### (PET resin)

To 100 parts by weight of dimethyl phthalate and 65 parts by weight of ethylene glycol were charged, and 0.05 parts by weight of magnesium acetate hydrate was added as a catalyst for ester exchanging reaction and esterification reaction was carried out according to a usual method. To thus prepared product, 0.05 parts by weight of antimony trioxide and 0.03 parts by weight of trimethyl phosphate were added. Then the temperature was gradually raised and pressure was reduced, and polymerization was carried out at 280 °C and 0.5 x 9.8 Pa. Thus polyethylene phthalate (PET) having an intrinsic viscosity of 0.70 was obtained.

Biaxial-stretched Pet film was prepared as follows using the above obtained PET resin.

### (Biaxial-stretched PET film)

The above obtained PET resin was pelletized and dried for 8 hours at 150 °C, and then melted and extruded through a T-die at 285 °C into a layer form and cooled and solidified while contacting onto a cooling roller at 30 °C by applying static electricity to obtain non-stretched film. The non-stretched film was lengthwise stretched by 3.3 times at 80 °C by a roller type length direction stretching machine. Thus obtained mono-axial stretched film was continuously subjected to widthwise stretching by a tenter type widthwise stretching machine. The film was stretched at 90 °C by 50% of the whole widthwise stretching ratio in the first stretching zone of the stretching machine and then further stretched at 100 °C in the second stretching zone so that the widthwise stretching ration was made to 3.3 times. Thereafter, the film was subjected to pre-thermal treatment at 70 °C for 2 seconds and thermally fixed at 150 °C for 5 seconds in the first fixing zone and for 15 seconds at 220 °C in the second fixing zone. Then the film was subjected to relaxation by 5% in the width direction at 160 °C and cooled by room temperature after taking out from the tenter machine and released form the clips. The resultant film was slit and winded up to obtain biaxial-stretched PET film with a thickness of 175 µm. The Tg of the biaxial-stretched film was 79 °C. The fluctuation range of the thickness of thus obtained film was 2%.

The surface, on which the image forming layer to be provided, of biaxial-stretched PET film was subjected to corona discharge treatment of 8 W/m²·min and a subbing layer coating composition a-1 was coated on this surface so as to make the layer thickness of 0.8 µm and dried 123 °C to provide a subbing layer A-1 on the hydrophilic side of the film.

The surface opposite to the above hydrophilic surface was subjected to corona discharge of 8 W/m²·min, and a subbing layer coating composition b-1 was coated at 23 °C and dried at 123 °C to form a backside subbing layer B-1 of 0.1 µm having anti-static ability.

Both of the subbed surfaces A-1 and B-1 were subjected to corona discharge treatment of 8 W/m²·min and a subbing layer coating composition a-2 was coated on the subbing layer A-1 so as to make the layer thickness to 0.1 µm and dried at 123 °C for providing a Subbing layer A-2. Besides, a subbing layer coating composition b-2 was coated on the subbing layer B-1 so as to make the layer thickness of 0.2 µm and dried at 123 °C for providing a subbing layer B-2, and thermally treated for 2 minutes at 140 °C to obtain a subbed sample.

### (Subbing layer coating composition a-1)

| | |
|---|---|
| Latex of three-component copolymer of styrene/glycidyl methacrylate/butyl acrylate in a ratio of 60/39/1 (Tg = 75 °C), solid content of 30% by weight | 250 g |
| Latex of three-component copolymer of styrene/glycidyl methacrylate/butyl acrylate in a ratio of 20/40/40 (Tg = 20 °C), solid content of 30% by weight | 25 g |
| Anionic surfactant S-1 (2% by weight) | 30 g |

Make to 1 kg by water

### (Subbing layer coating composition b-1)

| | |
|---|---|
| Metal oxide compound F-1 SnO₂ sol, 8.3% by weight*) | 109.5 g |
| Latex of three-component copolymer of styrene/butyl acrylate/hydroxymethacrylate in a ratio of 27/45/28 (Tg = 45 °C), solid content of 30% by weight | 3.8 g |
| Latex of three-component copolymer of styrene/glycidyl methacrylate/butyl acrylate in a ratio of 20/40/40 (Tg = 20 °C), solid content of 30% by weight | 15 g |
| Anionic surfactant S-1 (2% by weight) | 25 g |

| | |
|---|---|
| *: Preparation of metal oxide compound F-1 (colloidal dispersion of tin oxide) | |

Make to 1 kg by distilled water

A uniform solution was prepared by dissolving 65 g of tin(IV) oxide in 2,000 ml of a mixed solvent of water/ethanol. The solution was boiled to obtain co-precipitate. The co-precipitate was separated by decantation and washed several times by distillated water. After confirmation of no presence of chlorine ion in the water used for washing by adding a silver nitrate solution, distillated water was added to the precipitate to make the total amount to 2,000 ml. Moreover, 40 ml of 30% ammonia water was added and the resultant solution was concentrated by heating by 470 ml and then 300 ml of water was added to prepare a colloidal dispersion of tin oxide.

### (Subbing layer coating composition a-2)

| | |
|---|---|
| Modified water-soluble polyester L-4 solution (23% by weight) | 31 g |
| Five percent-aqueous solution of Exceval SR-2117 (copolymer of poly(vinyl alcohol) and ethylene manufactured by Kuraray Co., Ltd.) | 58 g |
| Anionic surfactant S-1 (2% by weight) | 6 g |
| Hardener H-1 (0.5% by weight) | 100 g |
| Two percent by weight-dispersion of Pear-like silica matting agent Seahoster KE-P50 manufactured by Nippon Shokubai Co., Ltd. | 10 g |

Make to 1,000 ml by distilled water

### (Subbing layer coating composition b-2)

| | |
|---|---|
| Modified water-soluble polyester L-3 solution (18% by weight) | 150 g |
| Anionic surfactant S-1 (2% by weight) | 6 g |
| Two percent by weight-dispersion of Pear-like silica matting agent Seahoster KE-P50 manufactured by Nippon Shokubai Co., Ltd. | 10 g |

Make to 1,000 ml of distillated water

### Anionic surfactant S-1

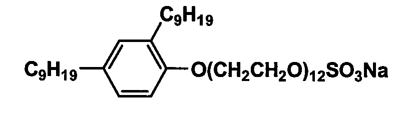

### Hardener H-1

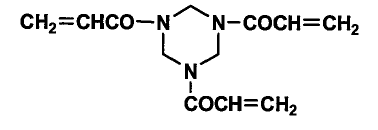

### (Preparation of solution of water-soluble polyester A-1)

Thirty five point four parts by weight of dimethyl terephthalate, 33.63 parts by weight of dimethyl isophthalate, 17.92 parts by weight of sodium salt of dimethyl 5-sulfoisophthalate, 62 parts by weight of ethylene glycol, 0.065 parts by weight of calcium nitrate and 0.022 parts by weight of manganese acetate tetrahydrate were subjected to ester exchanging reaction at a temperature of from 170 to 220 °C under nitrogen gas stream while distilling out methanol, and then 0.04 parts by weight of trimethyl phosphate, 0.04 parts by weight of antimony trioxide as a polymerization catalyst and 6.8 parts by weight of 1,4-cyclohexanedicarboxylic acid were added and esterification reaction was carried out at a temperature of from 220 to 235 °C while distilling out about theoretical amount of water. After that, the reacting system was reduced in pressure and raised in temperature spending for 1 hour and condensate-polymerization was carried out at 280 °C and not more than 133 Pa for 1 hours to prepare water-soluble polyester A-1. The intrinsic viscosity of water-soluble polyester A-1 was 0.33.

In a 2L three-mouthed flask attached with a stirrer, a reflux cooler and a thermometer, 850 ml of purified water was charged and 150 g of water-soluble polyester A-1 was gradually added while rotating the stirring wings. After stirring for 30 minutes at room temperature, the liquid was heated by 98 °C spending 1.5 hours and the water-soluble polyester was dissolved for 3 hours at this temperature. After completion of heating, the solution was cooled by room temperature spending 1 hour and stood for one night. Thus 15% by weight solution of water-soluble polyester A-1 was prepared.

### (Preparation of modified water-soluble polyester L-3 solution)

Into a 3L four-mouthed flask attached with a stirring wings, a reflux cooler, a thermometer and a dropping funnel, 1,900 ml of the above 15% by weight solution of water-soluble polyester A-1 was charged and the solution was heated by 80 °C while rotating the stirring wings. Into the solution, 6.52 ml of a 24% by weight solution of ammonium peroxide was added and then a monomer mixture composed of 35.7 g of ethyl acrylate and 35.7 g of methyl methacrylate was dropped spending 30 minutes and the reaction was further continued for 3 hours. After that, the reacting liquid was cooled by 30 °C or less and filtered to prepare a modified water-soluble polyester L-3 solution having a concentration of solid component of 18% by weight.

### (Preparation of solution of water-soluble polyester)

Thirty five point four parts by weight of dimethyl terephthalate, 33.63 parts by weight of dimethyl isophthalate, 17.92 parts by weight of sodium salt of dimethyl 5-sulfoisophthalate, 62 parts by weight of ethylene glycol, 0.065 parts by weight of calcium nitrate and 0.022 parts by weight of manganese acetate tetrahydrate were subjected to ester exchanging reaction at a temperature of from 170 to 220 °C under nitrogen gas stream while distilling out methanol, and then 0.04 parts by weight of trimethyl phosphate, 0.04 parts by weight of antimony trioxide as a polymerization catalyst and 6.8 parts by weight of 1,4-cyclohexanedicarboxylic acid were added and esterification reaction was carried out at a temperature of from 220 to 235 °C while distilling out about theoretical amount of water.

After that, the reacting system was reduced in pressure and raised in temperature spending for 1 hour and condensate-polymerization was carried out at 280 °C and not more than 133 Pa for 1 hour to prepare water-soluble polyester. The intrinsic viscosity of the water-soluble polyester was 0.33 (100 ml/g), and Mw was from 80,000 to 100,000.

In a 2L three-mouthed flask attached with a stirrer, a reflux cooler and a thermometer, 850 ml of purified water was charged and 150 g of the water-soluble polyester was gradually added while rotating the stirring wings. After stirring for 30 minutes at room temperature, the liquid was heated by 98 °C spending 1.5 hours and the water-soluble polyester was dissolved for 3 hours at this temperature. After completion of heating, the solution was cooled by room temperature spending 1 hour and stood for one night. Thus a 15% by weight solution of water-soluble polyester was prepared.

### (Preparation of modified water-soluble polyester L-4 solution)

Into a 3L four-mouthed flask attached with a stirring wings, a reflux cooler, a thermometer and a dropping funnel, 1,900 ml of the above 15% by weight solution of water-soluble polyester A-1 was charged and the solution was heated by 80 °C while rotating the stirring wings. Into the solution, 6.52 ml of a 24% by weight solution of ammonium peroxide was added and then a monomer mixture liquid composed of 28.5 g of glycidyl methacrylate, 21.4 g of ethyl acrylate and 21.4 g of methyl methacrylate was dropped spending 30 minutes and the reaction was further continued for 3 hours. After that, the reacting liquid was cooled by 30 °C or less and filtered to prepare a solution of modified water-soluble polyester B-1 (vinyl type component modifying ratio of 20% by weight) having a concentration of solid component of 18% by weight. A solution of one in which the vinyl type component modifying ratio was made to 5% by weight was referred to as modified water-soluble polyester coating L-4 solution.

### (Preparation of back-coat layer coating composition)

The composition listed in Table 1 was sufficiently mixed by a homogenizer and filtered to prepare a back-coat layer coating composition.

**Table 1**

| Material | Adding amount |
|---|---|
| Colloidal silica: SNOWTEX 1-XS (Nissan Chemical Industries, Ltd., Solid content: 20% by weight) | 33.60g |
| Acryl emulsion: DK-50 (Gifu Shellac Co., Ltd., Solid content: 48% by weight) | 14.00 g |
| Matting agent (PMMA, Average particle diameter: 5.5 µm) | 0.56g |
| Purified water | 51.84g |
| Solid content (percent by weight) | 14% by weight |

### (Coating of back-coat layer)

The back-coat layer coating composition was coated on the subbing layer coated side B by a wire bar #6 and passed through a drying zone having a length of 15 m set at 120 °C at a transferring rate of 50 m/minute. The coating amount of the back-coat layer coating composition was 1.8 g/m².

### (Preparation of lower hydrophilic layer coating composition)

The composition listed in Table 2 was sufficiently mixed by a homogenizer and filtered and lower hydrophilic layer coating compositions A, B, C and D were prepared.

**Table 2**

| Lower hydrophilic layer coating liquid | A | B | C | D |
|---|---|---|---|---|
| Material | * 1 | * 1 | * 1 | * 1 |
| Porous metal oxide: SILTON JC-40 (Mizusawa Industrial Chemicals Ltd.) | 11.1% | 11.1% | 11.1% | 11.1% |
| Aqueous swollen gel having a concentration of 5% by weight prepared by strongly stirring stratified clayey mineral montmorillonite: Mineral Colloid MO, (Mizusawa Industrial Chemicals Ltd., porous aluminosilicate particle having average an particle diameter of 4 µm) by a homogenizer. | 1.1% | 1.1% | 1.1% | 1.1% |
| Aqueous dispersion of Cu-Fe-Mn type Black pigment Black powder TN-3550 (Dainichiseika Color & Chemicals Mfg. Co., Ltd., particle diameter: about 0.1 µm) having a solid content of 40% by weight including 2% by weight of dispersing agent. | 20.0% | 20.0% | 20.0% | 20.0% |
| Carboxymethyl cellulose (Kanto Chemical Co., Inc.) | 0.6% | 0.6% | 0.6% | 0.6% |
| Trisodium phosphate dodecahydrate (Kanto Chemical Co., Inc.) | 0.3% | 0.3% | 0.3% | 0.3% |
| Colloidal silica SNOWTEX XS (Nissan Chemical Industries, Ltd., solid content: 20% by weight) | 37.6% | 7.10% | 0.0% | 48.1% |
| Colloidal silica SNOWTEX ZL (Nissan Chemical Industries, Ltd., solid content: 20% by weight) | 3.0% | 3.0% | 0.0% | 3.0% |
| Surface coated melamine resin particle: STM-6500S (Nissan Chemical Industries, Ltd., average particle diameter: 6.5 µm) | 15.0% | 15.0% | 9.6% | 15.0% |
| Silicone surfactant: FZ-2161 (Nippon Unicar Co., Ltd.) | 0.80% | 0.80% | 0.80% | 0.80% |
| Addition polymerizable compound: methoxypolyethylene glycol (N=9) acrylate | 10.00% | 40.00% | 55.00% | 0.00% |
| Polymerization initiator (IC-1) | 0.50% | 1.00% | 1.50% | 0.00% |
| Remarks | Inv. | Inv. | Inv. | Comp. |

| | | | | |
|---|---|---|---|---|
| * 1: Composition (% by weight), Inv.: Inventive, Comp.: Comparative | | | | |

### (Preparation of upper hydrophilic layer coating composition)

The compositions described in Table 3 were each sufficiently stirred by a homogenizer and filtered to prepare upper hydrophilic layer coating compositions A', B', C' and D'.

**Table 3**

| Upper hydrophilic layer coating liquid | A' | B' | C' | D' |
|---|---|---|---|---|
| material | * 1 | * 1 | * 1 | *1 |
| Porous metal oxide: SILTON JC-40 (Mizusawa Industrial Chemicals Ltd.) | 10.0% | 10.0% | 10.0% | 10.0% |
| Aqueous swollen gel having a concentration of 5% by weight prepared by strongly stirring stratified clayey mineral montmorillonite: Mineral Colloid MO, (Mizusawa Industrial Chemicals Ltd., porous aluminosilicate particle having average an particle diameter of 4 µm) by a homogenizer. | 2.0% | 2.0% | 2.0% | 2.0% |
| Aqueous dispersion of Cu-Fe-Mn type Black pigment Black powder TN-3550 (Dainichiseika Color & Chemicals Mfg. Co., Ltd., particle diameter: about 0.1 µm) having a solid content of 40% by weight including 2% by weight of dispersing agent. | 9.0% | 9.0% | 9.0% | 9.0% |
| Carboxymethyl cellulose (Kanto Chemical Co., Inc.) | 1.0% | 1.0% | 1.0% | 1.0% |
| Trisodium phosphate dodecahydrate (Kanto Chemical Co., Inc.) | 0.5% | 0.5% | 0.5% | 0.5% |
| Colloidal silica SNOWTEX S (Nissan Kagaku Co., Ltd., solid content: 30% by weight) | 13.0% | 5.0% | 13.0% | 13.0% |
| Colloidal silica SNOWTEX PSM (Nissan Chemical Industries, Ltd., solid content: 20% by weight) | 19.4% | 12.5% | 19.5% | 19.5% |
| Aluminosilicate : AMT-08 (Mizusawa Industrial Chemicals Ltd.) | 25.0% | 20.0% | 30.0% | 30.0% |
| Colloidal silica: MP-4540 (Nissan Chemical Industries, Ltd., solid content: 40% by weight) | 15.00% | 15.00% | 15.00% | 15.00% |
| Addition polymerizable compound: methoxypolyethylene glycol (N=9) acrylate | 5.00% | 20.00% | 2.00% | 0.00% |
| Polymerization initiator (IC-1) | 0.10% | 0.50% | 0.10% | 0.00% |
| Remarks | Inv. | Inv. | Inv. | Comp. |

| | | | | |
|---|---|---|---|---|
| *1: Composition (% by weight), Inv.: Inventive, Comp.: Comparative | | | | |

### (Coating of lower and upper hydrophilic layers)

Lower hydrophilic layer coating compositions A, B, C and D were each coated by a wire bar # 5 as shown in Table 5 on the side (Subbed surface A) opposite to the surface on which the above back-coat layer was coated, and passed through a drying zone having a length of 15 m and set at 120 °C at a transferring rate of 15 m/minute. Continuously, upper hydrophilic layer coating compositions A, B, C and D were each coated by a wire bar # 3 as shown in Table 5 on the side (Subbed surface A) to the surface on which the above back-coat layer was coated, and passed through a drying zone having a length of 30 m and set at 120 °C at a transferring rate of 15 m/minute. The addition polymerizable compound in the hydrophilic layer was polymerized and hardened by irradiating the coated hydrophilic layer by UV light of principal wavelength of 365 nm with strength of 200 mW/cm² emitted from UV light irradiation devices provided at each of the exit of the drying zones. The coating amounts of the lower and upper hydrophilic layers were each 3.0 g/m² and 0.55 g/m², respectively. The coated samples were each thermally treated for 48 hours at 48 hours.

### (Solution preparation and coating of image forming layer)

An image forming layer coating composition (aqueous liquid) having the composition shown in Table 4 was prepared in which solid content was 10% by weight. The image forming layer coating composition was coated on the upper hydrophilic layer by a bar coater #5, and transferred in a drying zone having a length of 30 m and set at 70 °C at a transferring rate of 50 m/minute to form an image forming layer. Thus lithographic printing plate materials 1 to 16 shown in Table 5 were prepared. The coating amount of the image forming layer was 0.5 g/m². The coated samples were each subjected to thermal treatment at 50 °C for 24 hours.

**Table 4**

| Composition | Content (Percent by weight of solid components) |
|---|---|
| Carnauba wax dispersion A-118 (Gifu Shellac Mfg., Co., Ltd.) | 67.5 |
| Microcrystalline wax dispersion A-205 (Gifu Shellac Mfg., Co., Ltd.) | 23 |
| Sodium polyacrylate DL522 (Nippon Shokubai Co., Ltd.) | 7.5 |
| Penon JE-66 (Nippon Starch Chemical Co., Ltd.) | 2 |

The prepared lithographic printing plate materials were each silted in a width of 730 mm and cut into 30 m length, and wound on a paper core. Thus rolled shaped lithographic printing plate materials 1 to 16 were obtained. The lithographic printing plate materials were subjected to the following evaluations.

### <<Evaluation method>>

### (Image formation)

The sample was exposed to various dot images of 175 line/inch by a plate setter SS-830, manufacture by Konica Minolta MG Co., Ltd., having a semiconductor laser.

### (Printing)

Printing test was carried out by using a printing machine DAIYA F-1, manufactured by Mitsubishi Heavy Industries, Ltd., Mu-Coat Paper, a two percent by weight-solution of dampening water of Astromark 3, manufactured by Nikken Kagaku Kenkyusho Co., Ltd., and an ink Toyo TK Hy-Unity M Red, manufactured by Toyo Ink Mfg. Co., Ltd. The printing was carried out by back surface printing and a powder NIKKALYCO, manufactured by Nikka Ltd., was used on the occasion of printing at a powder scale 1 of the printing machine.

Printed matters were observed for evaluating the properties of the printing plate materials.

### (Evaluation of on-press developability)

Number of paper sheet until a printed image having sufficient S/N ratio (there was no contamination on the background of non-image area, namely the non-image area of the image forming layer was removed on the printing machine and the density of printed image was within suitable range) namely the number of lost paper sheets was evaluated. The printing plate causes smaller number of lost paper sheet was superior and that causing 40 or more lost paper sheets posed a problem in practical use.

### (Running durability)

The end point of the running durability was defined by the time at which the lacking of small 3%-dot or lowering of the density of a solid image was confirmed. The printing durability of the plate was evaluated by the number of the paper sheet until the end point.

### (Evaluation of resistivity to pressure fogging)

The surface of the printing plate before exposition was rubbed by a sapphire stylus having a diameter of 0.5 mm while applying a load of 200 g, and the adhesion degree on the non-image area after development by 20 sheets of paper was evaluated according to the following norms.
A: No ink adhered.
B: The ink adheres a little.
C: The ink adhered.

The test results are listed in Table 5.

**Table 5**

| Lithographic printing plate material | Hydrophilic layer | | Evaluation result | | | Remarks |
|---|---|---|---|---|---|---|
| | Lower hydrophilic layer coating liquid | Upper hydrophilic layer coating liquid | On-press developability (Sheets | Printing durability (Sheets) | Pressure resistivity (Rank) | |
| 1 | A | A' | 15 | 26,000 | B | Inventive. |
| 2 | A | B' | 25 | 28,000 | A | Inventive. |
| 3 | A | C' | 15 | 24,000 | A | Inventive. |
| 4 | A | D' | 15 | 22,000 | B | Inventive. |
| 5 | B | A' | 15 | 28,000 | A | Inventive. |
| 6 | B | B' | 25 | 30,000 | A | Inventive. |
| 7 | B | C' | 15 | 24,000 | A | Inventive. |
| 8 | B | D' | 25 | 23,000 | A | Inventive. |
| 9 | C | A' | 30 | 30,000 | A | Inventive. |
| 10 | C | B' | 45 | 32,000 | A | Inventive. |
| 11 | C | C' | 25 | 29,000 | A | Inventive. |
| 12 | C | D' | 25 | 26,000 | A | Inventive. |
| 13 | D | A' | 15 | 24,000 | B | Inventive. |
| 14 | D | B' | 25 | 26,000 | B | Inventive. |
| 15 | D | C' | 15 | 20,000 | B | Inventive. |
| 16 | D | D' | 15 | 16,000 | C | Comparative |

As is cleared form Table 5, a lithographic printing plate material excellent in the on-press developability, running durability, and resistivity to pressure fogging, the production method of the lithographic printing plate material and the printing method using the lithographic printing plate material are provided by the invention.

## Claims

1. A lithographic printing plate material for on-press development having a hydrophilic layer and a thermo-sensitive image forming layer piled on a support, wherein the hydrophilic layer is formed by coating a coating composition containing a compound having an addition polymerizable unsaturated bond and a polymerization initiator onto the support and thereafter polymerizing the compound having the addition polymerizable unsaturated bond.

2. The lithographic printing plate material of claim 1, wherein the compound having the addition polymerizable unsaturated bond and the polymerization initiator each has a water solubility of not less than 1% by weight.

3. A production method of a lithographic printing plate material for on-press development having a hydrophilic layer and a thermo-sensitive image forming layer piled on a support, wherein the hydrophilic layer is formed by coating a coating composition containing a compound having an addition polymerizable unsaturated bond and a polymerization initiator onto the support and polymerizing the compound having the addition polymerizable unsaturated bond by light or heat.

4. The production method of a lithographic printing plate material of 3, wherein the compound having the addition polymerizable unsaturated bond and the polymerization initiator each has a water solubility of not less than 1% by weight.

5. A printing method comprising the steps of forming an image on the lithographic printing plate material of claim 1 or 2 by using a thermal head or a thermal laser and thereafter developing the image by dampening water or both dampening water and printing ink on a lithographic printing machine and printing.
